# EUROPEAN PATENT SPECIFICATION

(11) **EP 3 327 783 B1**
(45) Date of publication and mention of the grant of the patent: **03.08.2022**
(21) Application number: 17192303.0
(22) Date of filing: 21.09.2017
(51) Int. Cl.: H01L 27/32, G06F 3/041

(54) **FLEXIBLE ELECTROLUMINESCENT DISPLAY DEVICE**
FLEXIBLE ELEKTROLUMINESZENTE ANZEIGEVORRICHTUNG
AFFICHEUR ÉLECTROLUMINESCENT FLEXIBLE

(30) Priority: 25.11.2016 KR 20160158462
(43) Date of publication of application: 30.05.2018
(73) Proprietor: LG Display Co., Ltd., Seoul, 07336 (KR)
(72) Inventor: RHE, Ruda, 10845 Paju-si, Gyeonggi-do (KR); LEE, Deuksu, 10845 Paju-si, Gyeonggi-do (KR); LEE, Jeonghoon, 10845 Paju-si, Gyeonggi-do (KR); JUNG, Jihyun, 10845 Paju-si, Gyeonggi-do (KR); LEE, Jaegyun, 10845 Paju-si, Gyeonggi-do (KR)
(74) Representative: Viering, Jentschura & Partner mbB Patent- und Rechtsanwälte

(56) References cited:
- EP-A1- 3 001 479
- EP-A1- 3 217 265
- US-A1- 2015 380 679
- US-A1- 2016 315 284
- US-A1- 2017 237 025

## Description

### Field of the Invention

This disclosure relates to a flexible electroluminescent display device, and more particularly to a flexible electroluminescent display having a touch sensor.

### Discussion of the Related Art

Recently, various flat panel display devices capable of reducing weight and the volume, that is, disadvantages of a cathode ray tube (CRT), are being developed. Examples of such a flat panel display device include a liquid crystal display (LCD), a field emission display (FED), a plasma display panel (PDP), an electroluminescent display device and so on.

Because the flat panel display device is thin and light in weight, it is widely used as a display means in a mobile communication terminal or a portable information processing device. In particular, there is a growing demand for display panels that are thinner, lighter, and have lower power consumption in portable or mobile devices. Such display devices are being applied not only to mobile devices such as smart phones and tablet PCs, but also to various fields such as TVs (televisions), automobile displays, wearable devices and so on. Such display devices are required to be structurally modified in various ways to be applied to various fields.

According to this demand, in recent years, developments of a flexible electroluminescent display device capable of bending or folding have been actively progressing. For example, a flexible electroluminescent display device, which is manufactured so that display performance can be maintained even when it bends like paper by using a flexible material such as flexible plastic or metal foil as a substrate, is rapidly emerging as a next generation flat panel display device.

In general, such display devices require an interface to an input device that is convenient, simple, and can reduce malfunctions. According to such demands, a touch sensor has been proposed in which a user directly touches a screen with a hand or a pen to input information. Such a touch sensor is used in combination with a display device in various ways.

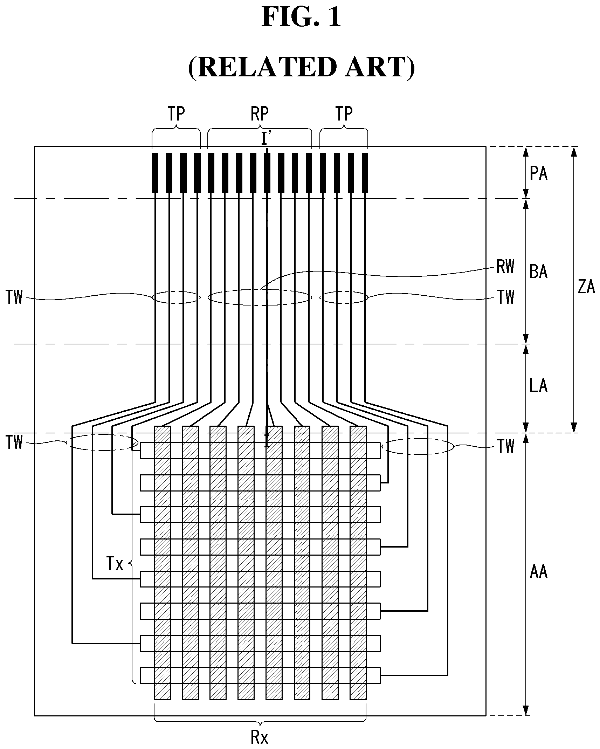

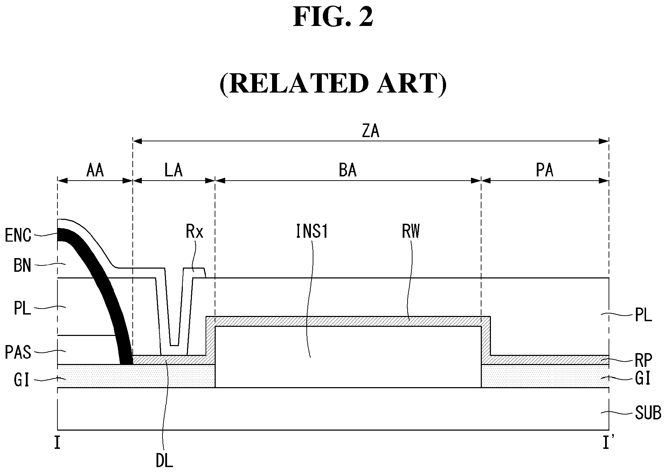

Hereinafter, a flexible electroluminescence display device (hereinafter, simply referred to as a flexible electroluminescence display device) having a conventional touch sensor will be described with reference to FIGS. 1 and 2.

FIG. 1 is a plan view schematically showing a related art flexible electroluminescence display device, and FIG. 2 is a cross-sectional view taken along a line I-I 'of FIG. 1.

Referring to FIGS. 1 and 2, a related art flexible electroluminescent display device includes an active area AA and a bezel area ZA. The bezel area ZA includes a link area LA, a bending area BA, and a pad area PA as areas outside the active area AA.

The active area AA is an area where an input image is displayed and information is input through a touch or proximity of an object such as a finger or a stylus pen. Display elements such as gate lines, data lines, thin film transistors, storage capacitors, organic light emitting diodes and so on for displaying an input image and touch sensors for sensing touch inputs are disposed in the active area AA.

In the active area AA in which the display elements are disposed, a gate insulation layer GI covering the gate lines and gate electrodes of thin film transistors, a passivation film PAS covering source and drain electrodes of the thin film transistors and data lines formed on the gate insulation layer GI, a planarization layer PL formed on the passivation film PAS, and a bank BN formed to expose organic light emitting diodes (not shown) disposed on the planarization layer PL, are disposed on a substrate SUB. An encapsulation layer ENC is disposed on the bank BN to prevent moisture from being permeated from the outside.

A touch sensor is formed on the encapsulation layer ENC. The touch sensor includes a plurality of first touch electrodes Tx arranged in parallel along a first direction and a plurality of second touch electrodes Rx arranged in parallel along a second direction crossing the first direction.

The data lines (not shown) extending from the active area AA, a plurality of first routing wires TW connected to the plurality of first touch electrodes Tx, and a plurality of second routing wires RW connected to the plurality of second touch electrodes Rx are disposed in the link area LA and the bending area BA.

The link area LA is an area located between the active area AA and the bending area BA. In the link area LA the data lines DL extending from the active area AA to the bending area BA, and the plurality of first and second routing wires TW and RW are arranged side by side. The plurality of first and second routing wires TW and RW are disposed on the gate insulation layer GI on the substrate SUB.

In the bending area BA, the data lines extending from the link area LA to the pad area PA, and the plurality of first and second routing wires TW and RW are arranged side by side, too. The plurality of first and second routing wires TW and RW are disposed on the gate insulation layer GI and a first insulation layer INS1 on the substrate SUB. The first insulation layer INS1 is formed of an organic insulation material.

In the pad area PA, pads for receiving signals supplied from the outside or for supplying signals transmitted from the active area AA are disposed. The pads include data pads (not shown) connected to the data lines DL and first and second touch pads TP and RP connected to the first and second routing wires TW and RW, respectively. The data pads (not shown) and the first and second touch pads TP and RP are disposed on the gate insulation layer GI formed on the substrate SUB.

In the above-described related art flexible electroluminescent display device, the substrate SUB may be formed of a flexible plastic material. The bending area BA is a flexible area and has flexibility. Since the bending area BA can be bent in the front or rear direction of the display device, stress acts on the bending area BA. If cracks or disconnections are generated in the data lines or the routing wires (hereinafter, referred to as signal wires) due to such stress, the signals are not supplied, thereby causing an abnormality in the display function or the touch function.

Therefore, in the related art flexible electroluminescence display device, in order to prevent the signal wires from being damaged due to the stress applied at the time of bending, the gate insulation layer GI which generates a lot of stress is replaced with the first insulation layer INS1 made of an organic insulation material under the signal wires of the bending area BA, and the planarization layer PL is disposed to cover the signal wires.

However, according to such a structure, since one mask process has to be added to provide (e.g., pattern) the first insulation layer INS 1 for reducing the stress under the signal wires in the bending area BA, the process time and manufacturing cost are increased.

US 2015/380679 A1 discloses that a display device includes a substrate including a first surface and a second surface and a curved part between the first surface and the second surface, a display element arranged on the first surface, a conducting layer connected with the display element and extending to the second surface from the first surface via the curved part, a plurality of protective layers having a lower ductility than the substrate and arranged in the substrate side and/or opposite side to the substrate side with respect to the conducting layer and along the curved part, wherein each of the plurality of protective layers spreading over the curved part, to a certain region of the first surface side from the curved part, and to a certain region of the second side from the curved part.

US 2016/315284 A1 discloses that a display device includes: a lower substrate comprising an active area, and a peripheral area outside the active area; a thin film transistor layer on the lower substrate; a plurality of pixel electrodes on the thin film transistor layer and in the active area; an encapsulating portion on the pixel electrode and encapsulating the pixel electrode; and a pattern layer comprising a plurality of patterns on the encapsulating portion, wherein the encapsulating portion covers a first area of the lower substrate and exposes a second area outside the first area, and the pattern layer comprises a crack preventing portion at the peripheral area.

EP 3 001 479 A1 discloses an organic light-emitting display device. The device comprises a display area comprising an organic light-emitting element on a lower substrate; a bezel area surrounding the display area; a transparent encapsulation unit comprising at least a first encapsulation layer, a first particle cover layer and a second encapsulation layer; and a first buffer layer. The first encapsulation layer covers the display area and the bezel area. The first particle cover layer covers the display area and at least a portion of the bezel area adjacent to the display area. The first buffer layer, apart from the first particle cover layer, covers at least another portion of the bezel area. The second encapsulation layer, which covers the first particle cover layer and the first buffer layer, is in contact with the first encapsulation layer at a contact surface between the first particle cover layer and the first buffer layer.

### SUMMARY OF THE INVENTION

An object of this disclosure is to provide an electroluminescent display device capable of reducing stress applied to signal wires in a bending area to protect the signal wires and reducing one mask process. Various embodiments provide an electroluminescent device according to claim 1. Also, various embodiments provide an electroluminescent device according to claim 3. Further embodiments are described in the dependent claims.

According to the electroluminescent display devices according to various embodiments of this disclosure, the first insulation layer and the planarization layer made of an organic insulation material are disposed at the upper and lower sides of the data link pattern, the first routing wire and the second routing wire, respectively, thereby increasing the flexibility of the electroluminescent display device. Therefore, it is possible to suppress occurrence of cracks to the maximum because the stresses applied to the data link pattern, the first routing wire and the second routing wire are reduced.

Also, according to various embodiments, the planarization layer between the substrate and the second metal layer in the bending area is formed by a same process as the planarization layer in the active area. Therefore, it is possible to obtain an effect of reducing one mask process compared with the related art.

Also, according to various embodiments, the data link pattern has a two-layer structure of the first data link pattern and the second data link pattern, each of the first and second routing wire has a two-layer structure, thereby forming a plurality of electrical paths. Therefore, when a bending occurs in the bending area, although a crack or a disconnection is occurred at any one of the plurality of electrical paths, the electric path is maintained by the other ones. Accordingly, it is possible to prevent defects of the electroluminescent display device due to the crack or the disconnection.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a plan view schematically showing a related art flexible electroluminescence display device;
FIG. 2 is a cross-sectional view taken along a line I-I 'of FIG. 1;
FIG. 3 is a plan view schematically showing a flexible electroluminescent display device having a touch sensor according to an embodiment of this disclosure;
FIG. 4 is an equivalent circuit diagram schematically showing one pixel area of the display panel shown in FIG. 3;
FIG. 5 is a plan view schematically showing a first embodiment of the flexible electroluminescence display device shown in Fig. 3;
FIG. 6A is a cross-sectional view taken along a line I-I 'of FIG. 5;
FIG. 6B is a cross-sectional view taken along a line II-II 'of FIG. 5;
FIG. 7 is a plan view schematically showing a second embodiment of the flexible electroluminescence display device shown in Fig. 3;
FIG. 8A is a cross-sectional view taken along a line I-I 'of FIG. 7;
FIG. 8B is a cross-sectional view taken along a line II-II 'of FIG. 7;
FIG. 9 is a plan view schematically showing a third embodiment of the flexible electroluminescence display device shown in Fig. 3;
FIG. 10A is a cross-sectional view taken along a line I-I 'of FIG. 9;
FIG. 10B is a cross-sectional view taken along a line II-II 'of FIG. 9;
FIG. 11A is a cross-sectional view of a first modification example taken along the line I-I 'of FIG. 9;
FIG. 11B is a cross-sectional view of a first modification example taken along the line II-II 'of FIG. 9;
FIG. 12A is a cross-sectional view of a second modification example taken along the line I-I 'of FIG. 9; and
FIG. 12B is a cross-sectional view of a second modification example taken along the line II-II 'of FIG. 9.

### DETAILED DESCRIPTION OF THE EMBODIMENTS

Hereinafter, embodiments of the present invention are described in detail with reference to the accompanying drawings. In the specification, the same reference symbols denote the same elements. In the following description, a detailed description of the known functions and constitutions will be omitted if it is deemed to obscure the embodiments of the present invention. Furthermore, the names of elements used in the following description have been selected by taking into consideration only the ease of writing this specification and may be different from the names of actual parts.

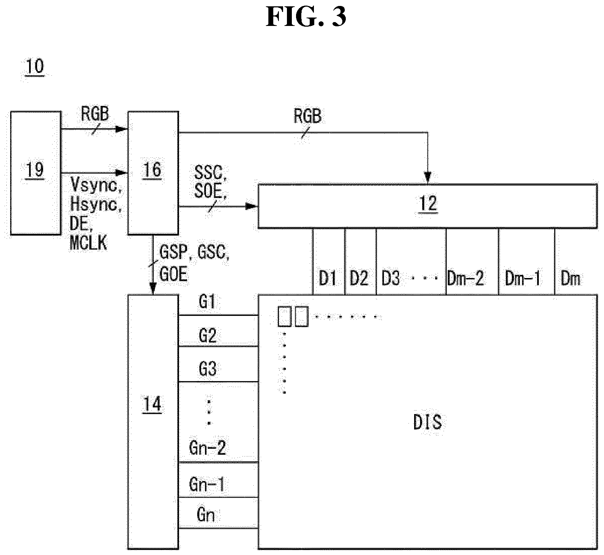

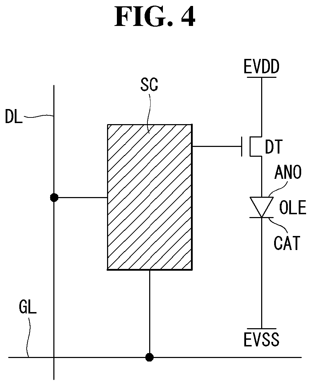

Hereinafter, a flexible electroluminescence display device according to an embodiment of this disclosure will be described with reference to FIGS. 3 and 4.

FIG. 3 is a plan view schematically showing a flexible electroluminescent display device having a touch sensor according to an embodiment of this disclosure. FIG. 4 is an equivalent circuit diagram schematically showing one pixel area of the display panel shown in FIG. 3.

Referring to FIG. 3, a flexible electroluminescent display device 10 according to this disclosure includes display driving circuits 12, 14 and 16 and a display panel DIS.

The display driving circuits 12, 14 and 16 include a data driving circuit 12, a gate driving circuit 14 and a timing controller 16, and write video data voltages of an input image to pixels of the display panel DIS. The data driving circuit 12 converts digital video data RGB input from the timing controller 16 into analog gamma compensation voltages to generate data voltages. The data voltages output from the data driving circuit 12 are supplied to the data lines D1 to Dm. The gate driving circuit 14 sequentially supplies gate pulses synchronized with the data voltages to the gate lines G1 to Gn to select the pixels of the display panel DIS to which the data voltages are written.

The timing controller 16 controls operation timings of the data driving circuit 12 and the gate driving circuit 14 using timing signals such as a vertical synchronization signal Vsync, a horizontal synchronization signal Hsync, a data enable signal DE, and a main clock signal MCLK, which are received from a host system 19. The data timing control signal for controlling the data driving circuit 12 includes a source sampling clock SSC, a source output enable signal SOE and so on. The gate timing control signal for controlling the gate driving circuit 14 includes a gate start pulse GSP, a gate shift clock GSC, a gate output enable signal GOE and so on.

The host system 19 may be implemented by one of a television system, a set-top box, a navigation system, a DVD player, a blue-ray player, a personal computer (PC), a home theater system, a phone system and so on. The host system 19 may include a system on chip (SoC) with a built-in scaler to convert the digital video data RGB of the input image into a format suitable for display on the display panel DIS. The host system 19 transmits the timing signals Vsync, Hsync, DE, and MCLK to the timing controller 16 together with the digital video data.

The pixel array of the display panel DIS includes pixels defined by data lines D1 to Dm (herein, m is a positive integer) and gate lines G1 to Gn (herein, n is a positive integer) .

Each of the pixels includes an organic light emitting diode OLE which is a self light emitting element.

Referring to FIG. 4, in the display panel DIS, a data line DL and a gate line GL cross over each other, and a pixel is disposed in an area defined by the crossing. Accordingly, pixels are arranged in the display panel DIS in the form of a matrix. Each pixel includes an organic light emitting diode OLE, a driving thin film transistor (hereinafter, referred to as a driving TFT) DT for controlling the amount of current flowing in the organic light emitting diode OLE, and a programming unit SC for setting the voltage between a gate electrode and a source electrode of the driving TFT DT.

The programming portion SC may include at least one switching TFT and at least one storage capacitor.

The switching TFT is turned on in response to a scan signal from the gate line GL, thereby applying a data voltage from the data line DL to one electrode of the storage capacitor.

The driving TFT DT controls the amount of current supplied to the organic light emitting diode OLE according to the magnitude of the voltage charged in the storage capacitor to control the amount of light emitted from the organic light emitting diode OLE. The amount of light emission of the organic light emitting diode OLE is proportional to the amount of current supplied from the driving TFT DT.

Each pixel is connected to a high potential voltage source and a low potential voltage source, and is supplied with a high potential voltage EVDD and a low potential voltage EVSS from a power generation unit (not shown).

The TFTs included in the pixel may be implemented as a p-type or an n-type transistor (e.g., field effect transistor). Further, the semiconductor layer of the TFTs constituting the pixel may include amorphous silicon, polysilicon, or an oxide. The organic light emitting diode OLE includes an anode electrode ANO, a cathode electrode CAT, and an organic light emitting layer interposed between the anode electrode ANO and the cathode electrode CAT. The anode electrode ANO is connected to the driving TFT DT. The organic light emitting layer may include an emission layer (EML), a hole injection layer (HIL), a hole transport layer (HTL), an electron transport layer (ETL) and an electron injection layer (EIL). The emission layer (EML) may be disposed between a hole layer including the hole injection layer (HIL) and the hole transport layer (HTL), and an electron layer including the electron transport layer (ETL) and the electron injection layer (EIL).

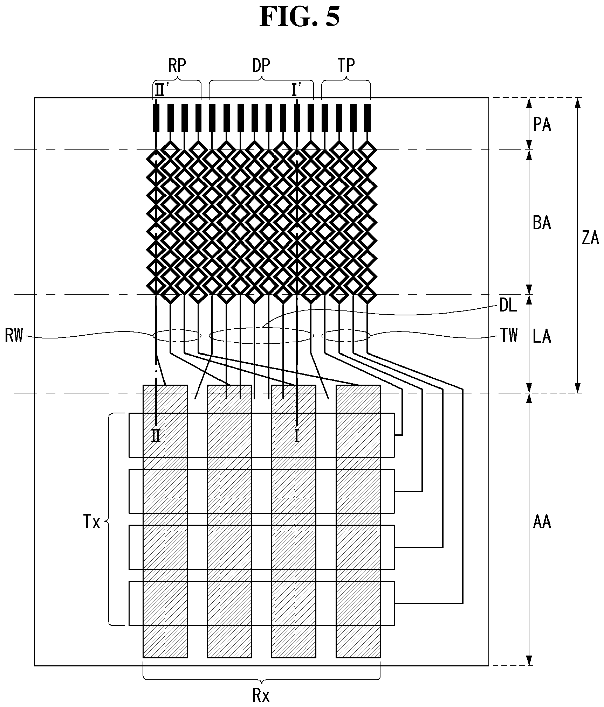

Next, a flexible electroluminescence display device according to a first embodiment of this disclosure will be described with reference to FIGS. 5 to 6B.

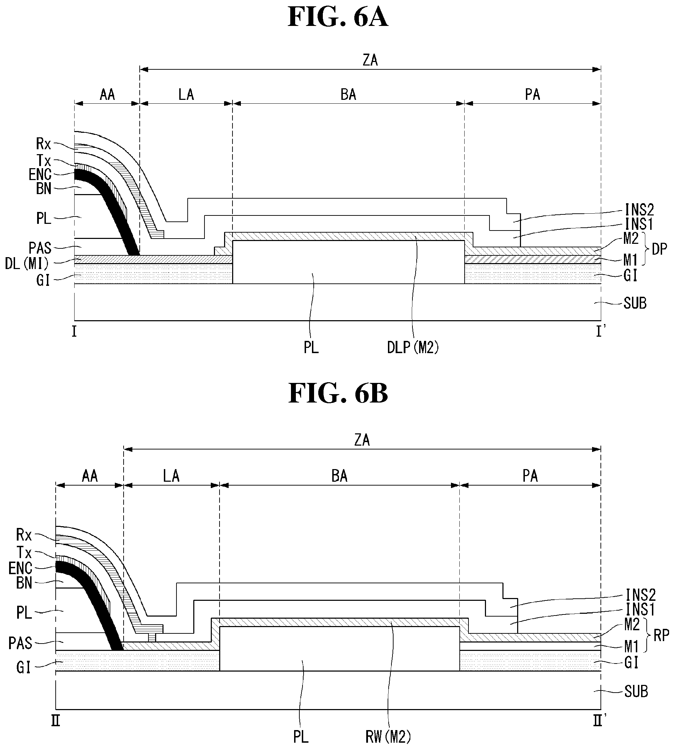

FIG. 5 is a plan view schematically showing a first embodiment of the flexible electroluminescence display device shown in Fig. 3. FIG. 6A is a cross-sectional view taken along a line I-I 'of FIG. 5, and illustrates a configuration of a data line DL and a data pad DP arranged in the active area AA and the bezel area ZA. FIG. 6B is a cross-sectional view taken along a line II-II 'of FIG. 5, and illustrates a second routing wire RW and a second touch pad RP in the bezel area ZA connected to a second touch electrode Rx disposed in the active area AA.

The flexible electroluminescent display device according to the first embodiment of this disclosure includes an active area AA and a bezel area ZA outside the active area AA. The bezel area ZA includes a link area LA, a bending area BA, and a pad area PA.

The active area AA is an area in which an input image is displayed and information is input through a touch or proximity of an object such as a finger or a stylus pen. There are display elements (for example, gate lines, data lines, thin film transistors, storage capacitors, organic light emitting diodes and so on) for displaying an input image and a touch sensor for sensing a touch in the active area AA.

In the active area AA, in which the display elements are disposed, a gate insulation layer GI covering the gate lines and gate electrodes of thin film transistors, a passivation film PAS covering source and drain electrodes of the thin film transistors and data lines formed on the gate insulation layer GI, a planarization layer PL formed on the passivation film PAS, and a bank BN formed to expose the organic light emitting diodes (not shown) disposed on the planarization layer PL, are disposed on a substrate SUB. An encapsulation layer ENC is disposed on the bank BN in the active area AA to prevent moisture from being permeated from the outside.

The substrate SUB is a flexible substrate having flexibility. For example, the substrate SUB may be a film type made of a flexible material selected from a group of a polyester-based polymer, a silicon-based polymer, an acrylic polymer, a polyolefin-based polymer, and copolymers thereof. Specifically, the flexible substrate may include one selected from a group of a polyethylene terephthalate (PET), polybutylene terephthalate (PBT), polysilane, polysiloxane, polysilazane, polycarbosilane, polyacrylate, polymethacrylate, polymethyl acrylate, polyethylacrylate, polyethylmetacrylate, cyclic olefin co-polymeric cyclic (COC), cyclic olefin polymer (COP), polyethylene (PE), polypropylene (PP), polyimide (PI), polymethylmethacrylate (PMMA), polystyrene (PS), polyoxymethylene (POM), polyetheretherketone (PEEK), polyestersulfone (PES), polytetrafluoroethylene (PTFE), polyvinyl chloride (PVC), polycarbonate (PC), polyvinylidene fluoride (PVDF), perfluoroalkyl polymer (PFA), styreneacrylonitrile copolymer (SAN), and combination thereof.

The gate insulation layer GI and the passivation film PAS may be formed of an inorganic insulation material such as silicon nitride or silicon oxide.

The planarization layer PL flattens the top of the substrate SUB. The planarization layer PL may be made of at least one selected from a group of resins such as polyacrylate-based resin, epoxy resin, phenolic resin, polyamide-based resin, polyimide-based resin, unsaturated polyester-based resin, poly-phenylenether-based resin, poly-phenylenesulfide-based resin, and benzocyclobutene. However, it is not limited thereto, and it can be formed of various other materials.

A touch sensor is formed on the encapsulation layer ENC. The touch sensor includes a plurality of first touch electrodes Tx arranged in parallel along a first direction and a plurality of second touch electrodes Rx arranged in parallel along a second direction crossing the first direction. A first insulation layer INS1 made of an organic insulation material is disposed between the first touch electrodes Tx and the second touch electrodes Rx or may be disposed entirely between the first touch electrodes Tx and the second touch electrodes Rx. In other words, the first insulation layer INS1 may be disposed only at those areas where the first touch electrodes Tx cross the second touch electrodes Rx, or it may be disposed also at other areas where the first and second touch electrodes Tx, Rx do not cross. A second insulation layer INS2 is disposed on the first insulation layer INS1 to cover the second touch electrodes Rx. The first touch electrodes Tx and the second touch electrodes Rx are formed of a transparent conductive material such as indium tin oxide (ITO), indium zinc oxide (IZO), or Gallium-doped Zinc Oxide (GZO).

There are data lines DL, first routing wires TW and second wires RW in the link area LA. Each of the data lines DL is extended from the active area AA, and includes a first metal layer M1. Each of the first routing wires TW is connected to a respective one of the first touch electrodes Tx, and each of the second wires RW is connected to a respective one of the second touch electrodes Rx. The first and second routing wires TW and RW are formed of a second metal layer M2.

In the link area LA, the first touch electrode Tx may be connected to the first routing wire TW on the gate insulation layer GI, and the second touch electrode Rx may be connected to the second routing wire RW exposed through a contact hole passing through the first insulation layer INS1.

In FIGS. 6A and 6B, the first insulation layer INS1 is an organic insulation layer for insulation of the first touch electrodes Tx and the second touch electrodes Rx, and the second insulation layer INS2 is an organic insulation layer for protecting the second touch electrodes Rx. The first and second insulation layers INS1 and INS2 may be formed using the same material as the planarization layer PL.

There are the planarization layer PL, data link patterns DLP, and first and second routing wires TW and RW in the bending area BA. The planarization layer PL in the bending area BA is disposed on the substrate SUB, and is the same as the planarization layer PL in the active area AA because the planarization layer PL in the bending area BA is formed together with the planarization layer PL in the active area AA. The data link patterns DLP are disposed on the planarization layer PL in the bending area BA and on portions of the data lines DL in the link area LA. Accordingly, the data link patterns DLP can be connected to the data lines DL formed of the first metal layer M1. The data link patterns DLP are formed of the second metal layer M2. The first and second routing wires TW and RW are connected to the first and second touch electrodes Tx and Rx, respectively (FIG. 6B shows only the second routing wire RW). The first and second routing wires TW and RW are also formed of the second metal layer M2. The first and second routing wires TW and RW as well as the data link patterns DLP are parallel with each other in the bending area BA.

The pad area PA includes pads for receiving signals supplied from the outside or for supplying signals transmitted from the active area AA. The pads include data pads DP and first touch pads TP and second touch pads RP.

Each of the data pads DP is disposed on the gate insulation film GI, and includes the first metal layer M1 and the second metal layer M2 on the first metal layer M1. The first metal layer M1 of the data pad DP is formed at the time of forming the data lines DL, and the second metal layer M2 of the data pad DP is extended from the data link pattern DLP of the bending area BA.

Each of the first and second touch pads TP and RP includes the first metal layer M1 disposed on the gate insulation layer GI and a second metal layer M2 on the first metal layer M1. The second metal layer M2 of the first touch pad TP is extended from the second metal layer M2 of the first routing wire TW, and the second metal layer M2 of the second touch pad RP is extended from the second metal layer M2 of the second routing wire RW.

The first and second metal layers M1 and M2 may be formed of a conductive material. The first and second metal layers M1 and M2 may be formed of a conductive material having excellent ductility to minimize occurrence of crack when the substrate SUB is bent. For example, each of the first and second metal layers M1 and M2 may be formed of a conductive material having excellent ductility such as gold (Au), silver (Ag), and aluminum (Al). However, the material forming the first and second metal layers M1 and M2 is not limited thereto, and may be selected from the group consisting of molybdenum (Mo), chromium (Cr), titanium (Ti), nickel (Ni), neodymium (Nd), copper (Cu) Magnesium (Mg), and alloy thereof.

According to the electroluminescent display device according to the first embodiment of this disclosure, the first insulation layer INS1 and the planarization layer PL made of an organic insulation material are disposed at the upper and lower sides of the data link pattern DLP, the first routing wire TW and the second routing wire RW, respectively, thereby increasing the flexibility of the electroluminescent display device. Therefore, it is possible to suppress occurrence of cracks to the maximum because the stresses applied to the data link pattern DLP, the first routing wire TW and the second routing wire RW are reduced.

Also, the planarization layer PL between the substrate SUB and the second metal layer M2 in the bending area BA is formed by a same process as the planarization layer PL in the active area AA. Therefore, it is possible to obtain an effect of reducing one mask process compared with the related art _{.}

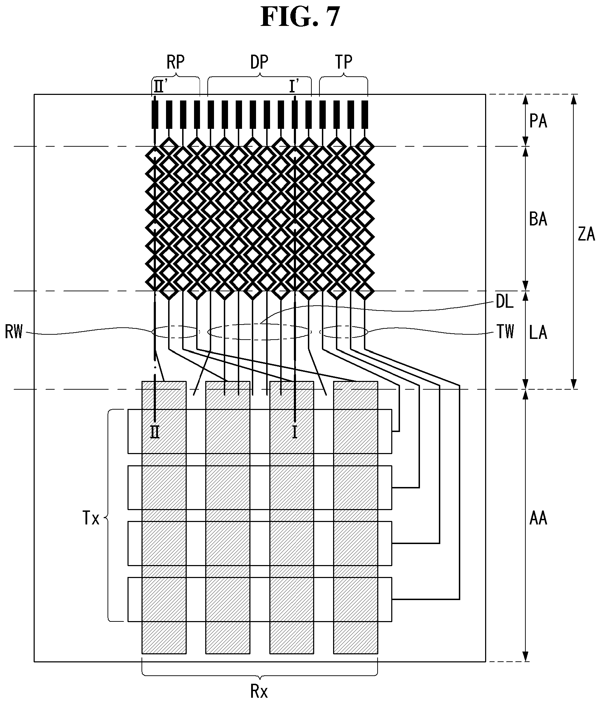

Next, a flexible electroluminescence display device according to a second embodiment of this disclosure will be described with reference to FIGS. 7 to 8B.

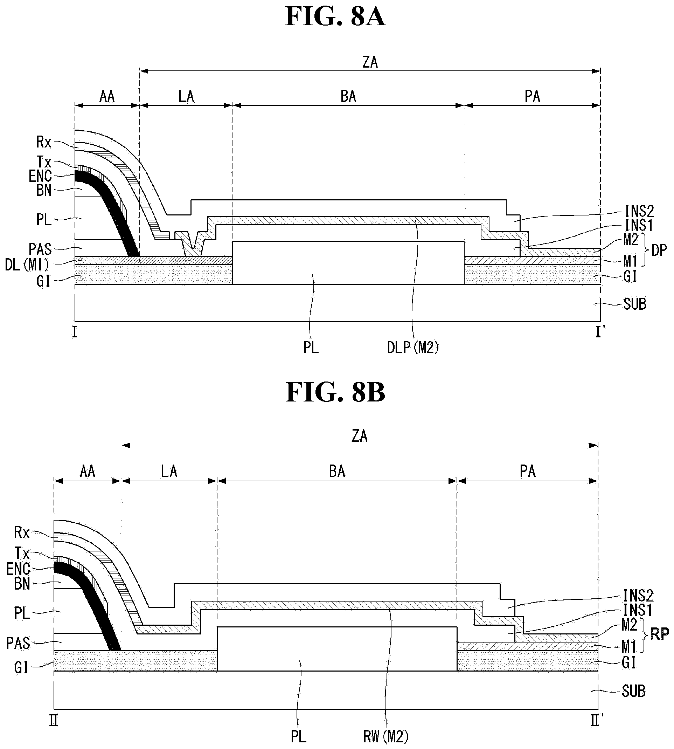

FIG. 7 is a plan view schematically showing a second embodiment of the flexible electroluminescence display device shown in Fig. 3. FIG. 8A is a cross-sectional view taken along a line I-I 'of FIG. 7, and illustrates a configuration of a data line DL, a data link pattern DLP and a data pad DP arranged in the active area AA and the bezel area ZA. FIG. 8B is a cross-sectional view taken along a line II-II 'of FIG. 7, and illustrates a second routing wire RW and a second touch pad RP in the bezel area ZA connected to a second touch electrode Rx disposed in the active area AA.

The flexible electroluminescent display device according to the second embodiment of this disclosure includes an active area AA and a bezel area ZA outside the active area AA. The bezel area ZA includes a link area LA, a bending area BA, and a pad area PA.

The active area AA is an area in which an input image is displayed and information is input through a touch or proximity of an object such as a finger or a stylus pen. There are display elements (for example, gate lines, data lines, thin film transistors, storage capacitors, organic light emitting diodes and so on) for displaying an input image and a touch sensor for sensing a touch in the active area AA.

In the active area AA in which the display elements are disposed, a gate insulation layer GI covering the gate lines and gate electrodes of thin film transistors, a passivation film PAS covering source and drain electrodes of the thin film transistors and data lines formed on the gate insulation layer GI, a planarization layer PL formed on the passivation film PAS, and a bank BN formed to expose the organic light emitting diodes (not shown) disposed on the planarization layer PL, are disposed on a substrate SUB. An encapsulation layer ENC is disposed on the bank BN in the active area AA to prevent moisture from being permeated from the outside.

The substrate SUB is a flexible substrate having flexibility. For example, the substrate SUB may be a film type made of a flexible material selected from a group of a polyester-based polymer, a silicon-based polymer, an acrylic polymer, a polyolefin-based polymer, and copolymers thereof. The flexible substrate can be formed using the same material as that of the flexible substrate of the first embodiment.

The gate insulation layer GI and the passivation film PAS may be formed of an inorganic insulation material such as silicon nitride or silicon oxide.

The planarization layer PL flattens the top of the substrate SUB. The same material as that described in the first embodiment can be used for the planarization layer PL.

A touch sensor is formed on the encapsulation layer ENC. The touch sensor includes a plurality of first touch electrodes Tx arranged in parallel along a first direction and a plurality of second touch electrodes Rx arranged in parallel along a second direction crossing the first direction. A first insulation layer INS1 made of an organic insulation material is disposed between the first touch electrodes Tx and the second touch electrodes Rx or may be disposed entirely between the first touch electrodes Tx and the second touch electrodes Rx. In other words, the first insulation layer INS1 may be disposed only at those areas where the first touch electrodes Tx cross the second touch electrodes Rx, or it may be disposed also at other areas where the first and second touch electrodes Tx, Rx do not cross. A second insulation layer INS2 is disposed on the first insulation layer INS 1 to cover the second touch electrode Rx. The first touch electrodes Tx and the second touch electrodes Rx are formed of a transparent conductive material such as ITO, IZO, or GZO.

There are data lines DL, data link patterns DLP, first routing wires TW and second wires RW in the link area LA. Each of the data lines DL is extended from the active area AA, and includes a first metal layer M1. Each of the data link patterns DLP is disposed on the first insulation layer INS1 covering the date line DL, and is connected to the data line DL exposed through contact hole passing through the first insulation layer INS 1. Each of the first routing wires TW is connected to each of the first touch electrodes Tx, and each of the second wires RW is connected to each of the second touch electrode Rx. The data link pattern DLP, the first and second routing wires TW and RW are formed of a second metal layer M2.

In the link area LA, the first routing wire TW is connected to the first touch electrode Tx exposed through a contact hole passing through the first insulation layer INS1, the second routing wire RW is directly connected to the second touch electrode Rx on the first insulation layer INS1.

In FIGS. 8A and 8B, the first insulation layer INS1 is an organic insulation layer for insulation of the first touch electrodes Tx and the second touch electrodes Rx, and the second insulation layer INS2 is an organic insulation layer for protecting the second touch electrodes Rx. The first and second insulation layers INS1 and INS2 may be formed using the same material as the planarization layer PL.

There are the planarization layer PL, data link patterns DLP, and first and second routing wires TW and RW in the bending area BA. The planarization layer PL in the bending area BA is disposed on the substrate SUB, and is the same as the planarization layer PL in the active area AA because the planarization layer PL in the bending area BA is formed together with the planarization layer PL in the active area AA. On the planarization layer PL, the first insulation layer INS1 is disposed. The data link patterns DLP are disposed on the first insulation layer INS1 in the bending area BA, and are extended to the link area LA and the pad area PA. The data link patterns DLP are formed of the second metal layer M2. The first and second routing wires TW and RW are connected to the first and second touch electrodes Tx and Rx, respectively (FIG. 8B shows only the second routing wire RW). The first and second routing wires TW and RW are also formed of the second metal layer M2. The first and second routing wires TW and RW as well as the data link patterns DLP are parallel with each other in the bending area BA.

The pad area PA includes pads for receiving signals supplied from the outside or for supplying signals transmitted from the active area AA. The pads include data pads DP and first touch pads TP and second touch pads RP.

Each of the data pads DP is disposed on the gate insulation film GI, and includes the first metal layer M1 and the second metal layer M2 on the first metal layer M1. The first metal layer M1 of the data pad DP is formed at the time of forming the data lines DL, and the second metal layer M2 of the data pad DP is extended from the data link pattern DLP of the bending area BA.

Each of the first and second touch pads TP and RP includes the first metal layer M1 disposed on the gate insulation layer GI and a second metal layer M2 on the first metal layer M1. The second metal layer M2 of the first touch pad TP is extended from the second metal layer M2 of the first routing wire TW, and the second metal layer M2 of the second touch pad RP is extended from the second metal layer M2 of the second routing wire RW.

The first and second metal layers M1 and M2 may be formed of a conductive material. The first and second metal layers M1 and M2 may be formed of a conductive material having excellent ductility to minimize occurrence of crack when the substrate SUB is bent. The first and second metal layers M1 and M2 may be formed using the same material as the first and second metal layers M1 and M2 of the first embodiment.

According to the electroluminescent display device according to the second embodiment of this disclosure, the second insulation layer INS2 and the first insulation layer INS1 made of an organic insulation material are disposed at the upper and lower sides of the data link pattern DLP, the first routing wire TW and the second routing wire RW, respectively, thereby increasing the flexibility of the electroluminescent display device. Therefore, it is possible to suppress occurrence of cracks to the maximum because the stresses applied to the data link pattern DLP, the first routing wire TW and the second routing wire RW are reduced.

Also, the planarization layer PL between the substrate SUB and the second metal layer M2 in the bending area BA is formed by a same process as the planarization layer PL in the active area AA. Therefore, it is possible to obtain an effect of reducing one mask process compared with the related art.

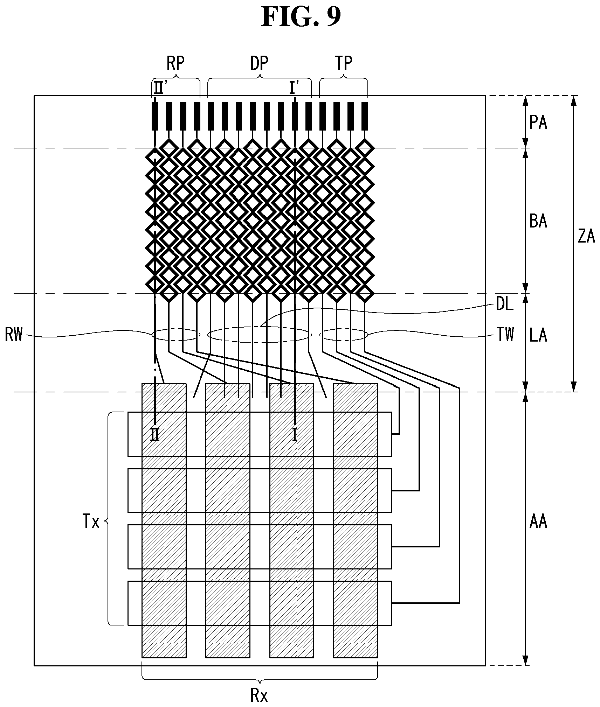

Next, a flexible electroluminescence display device according to a third embodiment of this disclosure will be described with reference to FIGS. 9 to 10B.

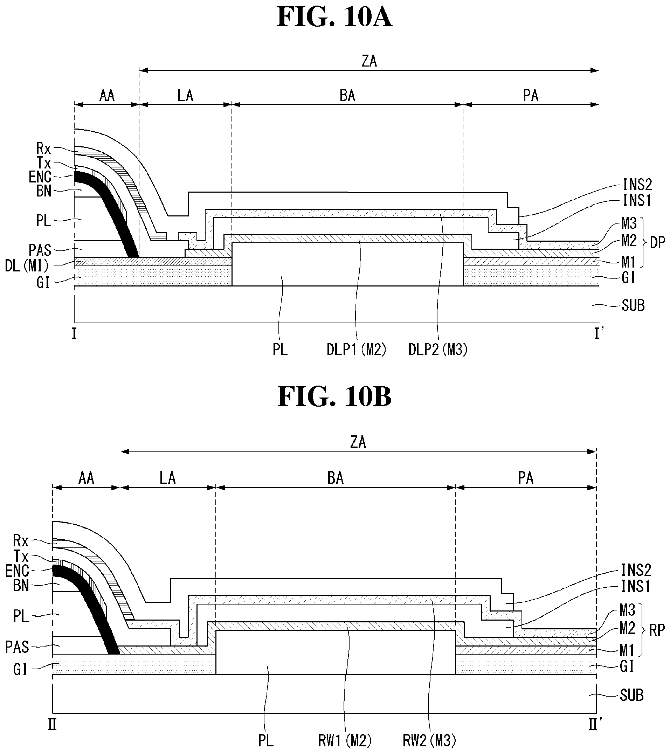

FIG. 9 is a plan view schematically showing a third embodiment of the flexible electroluminescence display device shown in Fig. 3. FIG. 10A is a cross-sectional view taken along a line I-I 'of FIG. 9, and illustrates a configuration of a data line DL, first and second data link patterns DLP1 and DLP2, and a data pad DP arranged in the active area AA and the bezel area ZA. FIG. 10B is a cross-sectional view taken along a line II-II 'of FIG. 9, and illustrates a second routing wire RW and a second touch pad RP in the bezel area ZA connected to a second touch electrode Rx disposed in the active area AA.

The flexible electroluminescent display device according to the third embodiment of this disclosure includes an active area AA and a bezel area ZA outside the active area AA. The bezel area ZA includes a link area LA, a bending area BA, and a pad area PA.

The active area AA is an area in which an input image is displayed and information is input through a touch or proximity of an object such as a finger or a stylus pen. There are display elements (for example, gate lines, data lines, thin film transistors, storage capacitors, organic light emitting diodes and so on) for displaying an input image and a touch sensor for sensing a touch in the active area AA.

In the active area AA in which the display elements are disposed, a gate insulation layer GI covering the gate lines and gate electrodes of thin film transistors, a passivation film PAS covering source and drain electrodes of the thin film transistors and data lines formed on the gate insulation layer GI, a planarization layer PL formed on the passivation film PAS, and a bank BN formed to expose the organic light emitting diodes (not shown) disposed on the planarization layer PL. An encapsulation layer ENC is disposed on the bank BN to prevent moisture from being permeated from the outside.

The substrate SUB is a flexible substrate having flexibility. For example, the substrate SUB may be a film type made of a flexible material selected from a group of a polyester-based polymer, a silicon-based polymer, an acrylic polymer, a polyolefin-based polymer, and copolymers thereof. The flexible substrate can be formed using the same material as that of the flexible substrate of the first embodiment.

The gate insulation layer GI and the passivation film PAS may be formed of an inorganic insulation material such as silicon nitride or silicon oxide.

The planarization layer PL flattens the top of the substrate SUB. The same material as that described in the first embodiment can be used for the planarization layer PL.

A touch sensor is formed on the encapsulation layer ENC. The touch sensor includes a plurality of first touch electrodes Tx arranged in parallel along a first direction and a plurality of second touch electrodes Rx arranged in parallel along a second direction crossing the first direction. A first insulation layer INS1 made of an organic insulation material may be disposed entirely between the first touch electrodes Tx and the second touch electrodes Rx or may be disposed only at the crossings thereof. In other words, the first insulation layer INS1 may be disposed only at those areas where the first touch electrodes Tx cross the second touch electrodes Rx, or it may be disposed also at other areas where the first and second touch electrodes Tx, Rx do not cross. A second insulation layer INS2 is disposed on the first insulation layer INS1 to cover the second touch electrode Rx. The first touch electrodes Tx and the second touch electrodes Rx are formed of a transparent conductive material such as ITO, IZO, or GZO.

There are data lines DL, data link patterns DLP1 and DLP2 consisting of two layers, first routing wires TW (not shown) consisting of two layers and second routing wires RW1 and RW2 consisting of two layers in the link area LA. Each of the data lines DL is extended from the active area AA, and is made of a first metal layer M1. Each of the data link patterns includes a first data link pattern DLP1 and a second data link pattern DLP2. The first data link pattern DLP1 is disposed on the data line DL in the link area LA. The second data link pattern DLP2 is disposed on the first insulation layer INS1 covering the first data link pattern DLP1, and is connected to the first data link pattern DLP1 exposed through a contact hole passing through the first insulation layer INS1. Each of the second routing wires RW includes a first wire layer RW1 and a second wire layer RW2. The first data link pattern DLP1 is disposed on the data line DL in the link area LA. The first wire layer RW1 of the second routing wire RW is disposed on the gate insulation layer GI in the link area LA. The second wire layer RW2 of the second routing wire RW is disposed on the first insulation layer INS1 covering the first wire layer RW1 of the second routing wire RW, and is connected to the first wire layer RW1 of the second routing wire RW exposed through a contact hole passing through the first insulation layer INS1. The second wire layer RW2 of the second routing wire RW is also directly connected to the second touch electrode Rx on the first insulation layer. Each of the first routing wires TW includes a first wire layer and a second wire layer (not shown) similar to the second routing wires RW. The first wire layer of the first routing wire TW may be directly connected to the first touch electrode Tx in the link area LA. The first data link pattern DLP1, the first wire layer of the first routing wire TW, and the first wire layer RW1 of the second routing wire RW are made of a second metal layer M2. The second data link pattern DLP2, the second wire layer of the first routing wire TW, and the second wire layer RW2 of the second routing wire RW are made of a third metal layer M3.

In FIGS. 10A and 10B, the first insulation layer INS1 is an organic insulation layer for insulation of the first touch electrodes Tx and the second touch electrodes Rx, and the second insulation layer INS2 is an organic insulation layer for protecting the second touch electrodes Rx. When the first insulation layer INS1 is formed only at the crossings of the first and second touch electrodes Tx and Rx, the second insulation layer INS2 may be omitted in the link area LA, the bending area BA, and the pad area PA. The first and second insulation layers INS 1 and INS2 may be formed using the same material as the planarization layer PL.

There are the planarization layer PL, data link patterns DLP1 and DLP2 consisting of two layers, first routing wires TW (not shown) consisting of two layers and second routing wires RW1 and RW2 consisting of two layers in the bending area BA. The planarization layer PL in the bending area BA is disposed on the substrate SUB, and is the same as the planarization layer PL in the active area AA because the planarization layer PL in the bending area BA is formed together with the planarization layer PL in the active area AA. On the planarization layer PL, the first data link pattern DLP1, the first wire layer of the first routing wire TW, and the first wire layer RW1 of the second routing wire extended from the link area LA are disposed. The second data link pattern DLP2, the second wire layer of the first routing wire TW, the second wire layer RW2 of the second routing wire extended from the link area LA are disposed on the first insulation layer INS1 covering the first data link pattern DLP1, the first wire layer of the first routing wire TW, and the first wire layer RW1 of the second routing wire. The data link patterns DLP1 and DLP2, the first routing wires TW and the second routing wires RW1 and RW2 are extended to the pad area PA. The first data link pattern DLP1, the first wire layer of the first routing wire TW, and the first wire layer RW1 of the second routing wire are formed of the second metal layer M2. The second data link pattern DLP2, the second wire layer of the first routing wire TW, the second wire layer RW2 of the second routing wire are made of the third metal layer M3. The first data link pattern DLP1, the first wire layer of the first routing wire TW, and the first wire layer RW1 of the second routing wire are parallel with each other on the planarization layer PL. The second data link pattern DLP2, the second wire layer of the first routing wire TW, the second wire layer RW2 of the second routing wire are parallel with each other on the first insulation layer INS1.

The pad area PA includes pads for receiving signals supplied from the outside or for supplying signals transmitted from the active area AA. The pads include data pads DP and first touch pads TP and second touch pads RP.

Each of the data pads DP is disposed on the gate insulation film GI, and includes the first metal layer M1, the second metal layer M2 extended from the link area LA on the first metal layer M1, and the third metal layer M3 extended from the link area LA on the second metal layer M2. That is, each of the data pads consists of three layers in which the first to third metal layers M1 to M3 are sequentially disposed on the gate insulation layer GI.

Each of the first and second touch pads TP and RP includes the first metal layer M1 on the gate insulation layer GI extended from the link area LA, the second metal layer M2 extended from the link area LA on the first metal layer M1, and the third metal layer M3 extended from the link area LA on the second metal layer M3. That is, each of the first and second touch pads TP and RP consists of three layers in which the first to third metal layers M1 to M3 are sequentially disposed on the gate insulation layer GI.

The first to third metal layers M1, M2 and M3 are formed of a conductive material and may be formed of a conductive material having excellent ductility to minimize occurrence of crack when the substrate SUB is bent. The first to third metal layers M1, M2 and M3 may be formed using the same material as the first and second metal layers M1 and M2 of the first embodiment.

According to the electroluminescent display device according to the third embodiment of this disclosure, the first insulation layer INS1 and the planarization layer PL made of an organic insulation material are disposed at the upper and lower sides of each the first data link pattern DLP1, the first wire layer (not shown) of the first routing wire TW, and the first wire layer RW1 of the second routing wire RW, and the second insulation layer INS2 and the first insulation layer INS1 made of an organic insulation material are disposed at the upper and lower sides of each the second data link pattern DLP2, the second wire layer (not shown) of the first routing wire TW, and the second wire layer RW2 of the second routing wire RW, thereby increasing the flexibility of the electroluminescent display device. Therefore, it is possible to suppress occurrence of cracks to the maximum because the stresses applied to the first and second data link patterns DLP1 and DLP2, the first and second wire layers of the first routing wire TW, and the first and second wire layers RW1 and RW2 of the second routing wire RW are reduced.

Also, each of the data link pattern DLP, the fist routing wire TW and the second routing wire RW located in the bending area BA has a two-layer structure. That is, the data link pattern DLP has a two-layer structure of the first data link pattern DLP1 and the second data link pattern DLP, the first routing wire TW has a two-layer structure of the first wire layer and the wire second layer (not shown), and the second routing wire RW has a two-layer structure of the first wire layer RW1 and the second wire layer RW2. Therefore, when a bending occurs in the bending area BA, although a crack or a disconnection is occurred at any one of the first data link pattern DLP1 and the second data link pattern DLP2, any one of the first wire layer and the second wire layer of the first routing wire (not shown), or any one of the first wire layer RW1 and the second wire layer RW2 of the second routing wire RW by stresses occurred due to the bending, the electric path is maintained by the other one. Accordingly, it is possible to prevent defects of the electroluminescent display device due to the crack or the disconnection.

Also, the planarization layer PL between the substrate SUB and the second metal layer M2 in the bending area BA is formed by a same process as the planarization layer PL in the active area AA. Therefore, it is possible to obtain an effect of reducing one mask process compared with the related art.

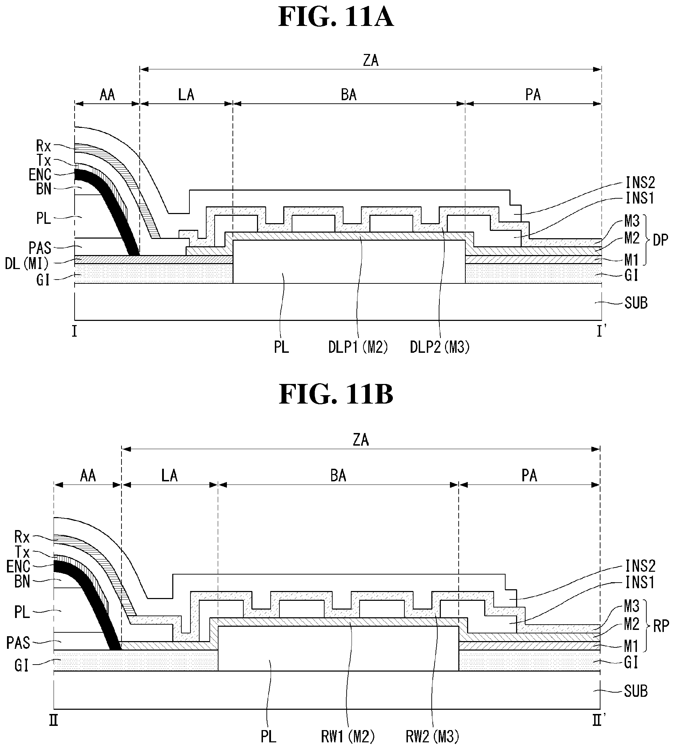

Next, a first modification example of the flexible electroluminescence display device according to the third embodiment of this disclosure will be described with reference to FIGS. 11A and 11B.

FIG. 11A is a cross-sectional view of a first modification example taken along a line I-I 'of FIG. 9, and illustrates a configuration of a data line DL, first and second data link patterns DLP1 and DLP2, and a data pad DP arranged in the active area AA and the bezel area ZA. FIG. 11B is a cross-sectional view of the first modification example taken along a line II-II 'of FIG. 9, and illustrates a second routing wire RW and a second touch pad RP in the bezel area ZA connected to a second touch electrode Rx disposed in the active area AA. In the FIGS. 11A and 11B, the first and second wire layers of the first routing wires TW and the first touch pad TP are omitted because they are similar to those of the second routing wires RW and the second touch pad RP.

The flexible electroluminescent display device according to the first modification example of the third embodiment of this disclosure shown in FIGS. 11A and 11B is substantially the same as the third embodiment except that the third metal layer M3 disposed in the bezel area ZA is connected to the second metal layer M2 through a plurality of contact holes passing through the first insulation layer INS1 in the bending area BA. Specifically, in the first modification example of the third embodiment of this disclosure, the second data link pattern DLP2 disposed on the first insulation layer INS1 is connected to the first data link pattern DLP1 through the contact holes passing through the first insulation layer INS1 in the bending area BA, and each of the second wire layers of the first and second touch routing wirings TW and RW disposed on the first insulation layer INS1 is electrically connected to each of the first wire layers of the first and second touch routing wirings TW and RW through the contact holes passing through the first insulation layer INS1 in the bending area BA. Therefore, further explanation is omitted to avoid duplication of descriptions.

In the first modification example of the third embodiment of this disclosure, even if the second metal layer M2 and the third metal layer M3 are disconnected at the same time by a crack and so on, it is possible to supply signals through various paths without going through the disconnection section because the third metal layer M3 may be connected to the second metal layer M2 at multiple positions through the plurality of contact holes.

Therefore, according to the first modified example of the third embodiment of this disclosure, it is possible to achieve the effects obtainable in the third embodiment, and also obtain a more stable effect of preventing the flexible electroluminescent display device from being failed by the occurrence of cracks due to the bending, as compared with the third embodiment.

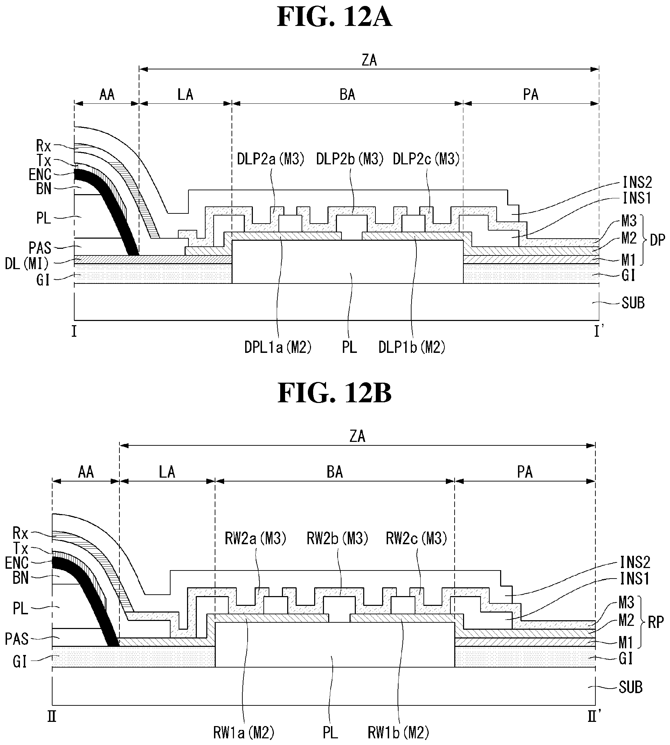

Next, a second modification example of the flexible electroluminescence display device according to the third embodiment of this disclosure will be described with reference to FIGS. 12A and 12B.

FIG. 12A is a cross-sectional view of a second modification example taken along a line I-I 'of FIG. 9, and illustrates a configuration of a data line DL, first and second data link patterns DLP1 and DLP2, and a data pad DP arranged in the active area AA and the bezel area ZA. FIG. 12B is a cross-sectional view of the second modification example taken along a line II-II 'of FIG. 9, and illustrates a second routing wire RW and a second touch pad RP in the bezel area ZA connected to a second touch electrode Rx disposed in the active area AA. In the FIGS. 12A and 12B, the first and second wire layers of the first routing wires TW and the first touch pad TP are omitted because they are similar to those of the second routing wires RW and the second touch pad RP.

The flexible electroluminescent display device according to the second modification example of the third embodiment of this disclosure shown in FIGS. 12A and 12B is different from the third embodiment in that the first data link pattern DLP1 made of the second metal layer M2 disposed on the planarization layer PL of the bezel area ZA consists of a plurality of first data link patterns DLPla and DLPlb separated from each other, the second data link pattern DLP2 made of a third metal layer M3 consists of a plurality of second data link patterns DLP2a, the first data link patterns DLPla and DLPlb are connected to each other by the second data link pattern DLP2b, and the second data link patterns DLP2a and DLP2b, and DLP2b and DLP2c are connected to each other by the first data link pattern DLPla and the first data link pattern DLP1b, respectively. Two first data link patterns DLPla and DLPlb are shown as an example. However, the number of first data link patterns may be different from two, e.g. greater than two. Three second data link patterns DLP2, DLP2b, and DLP2c are shown as an example, However the number of second data link patterns may be different from three, e.g. greater than three.

Also, the flexible electroluminescent display device according to the second modification example of the third embodiment of this disclosure shown in FIGS. 12A and 12B is different from the third embodiment in that the first wire layer of the second routing wire RW made of the second metal layer M2 disposed on the planarization layer PL in the bezel area ZA consists of a plurality of first wire pieces RW1a and RW1b separated from each other, the second wire layer of the second routing wire RW made of a third metal layer M3 consists of a plurality of second wire pieces RW2a, RW2b and RW2c, the plurality of first wire pieces RW1a and RW1b are connected to each other by the second wire piece RW2b, and the plurality of second wire pieces RW2a, RW2b and RW2c are connected to each other by the first wire pieces RWla and RW1b. Two first wire pieces RWla and RW1b are shown as an example. However, the number of first wire pieces may be different from two, e.g. greater than two. Three second wire pieces RW2a, RW2b, and RW2c are shown as an example, However the number of second wire pieces may be different from three, e.g. greater than three.

As described above, the flexible electroluminescent display device according to the second modified example of the third embodiment of this disclosure is substantially the same as the third embodiment except for the above differences. Therefore, further explanation is omitted to avoid duplication of descriptions.

In the second modification example of the third embodiment of this disclosure, even if the second metal layer M2 and the third metal layer M3 are disconnected at the same time by a crack and so on, it is possible to supply signals through various paths without going through the disconnection section because the third metal layer M3 may be connected to the second metal layer M2 at multiple positions through the plurality of contact holes.

Therefore, according to the second modification example of the third embodiment of this disclosure, it is possible to achieve the effects obtainable in the third embodiment, and also obtain a more stable effect of preventing the flexible electroluminescent display device from being failed by the occurrence of cracks due to the bending, as compared with the third embodiment.

For example, in the description of the embodiments of this disclosure, the data line and the touch routing wiring are described as examples of the signal lines arranged in the bezel area, but this disclosure is not limited thereto. It should be understood that this disclosure includes all signal lines extending from the active area to the pad area to supply and receive various signals such as a display signal, a power supply signal, a touch signal, and so on. The signal lines described in the claims do not only mean the data lines and the touch routing wiring, but have a meaning including signals above mentioned.

In the description of the embodiments of this disclosure, it describes that the first and second touch electrodes has a bar-shape. However, it is not intended to limit this disclosure but to merely illustrate one example for convenience of explanation. Accordingly, it is to be understood that this disclosure is not limited thereto and includes all known forms.

Accordingly, the technical scope of this disclosure is not limited to the contents described in the detailed description of the specification, but should be determined by the claims.

## Claims

1. An electroluminescent display device (10) comprising:
a substrate (SUB) having an active area (AA), and a bezel area (ZA) disposed outside the active area (AA), wherein the bezel area (ZA) includes a bending area (BA), a link area (LA) between the active area (AA) and the bending area (BA), and a pad area (PA) adjacent to the bending area (BA);
a gate insulation layer (GI) disposed on the substrate (SUB) in the active area (AA), the link area (LA) and the pad area (PA), but not in the bending area (BA);
a first portion of a planarization layer (PL) disposed in the active area (AA), and at least partially covering a first signal line (DL) extended from the active area (AA) to the link area (LA);
a second portion of the planarization layer (PL) disposed in the bending area (BA) and formed at a time of forming the first portion of the planarization layer (PL);
wherein the planarization layer (PL) is made of organic insulation material,
first and second touch electrodes (Tx, Rx) disposed to cross over each other on an encapsulation layer (ENC) above the first portion of the planarization layer (PL) with a first organic insulation layer (INS1) disposed between the first and second touch electrodes (Tx, Rx);
a first signal line link pattern (DLP) connected to the first signal line (DL) in the link area (LA) and extending to the bending area (BA) and disposed directly on the second portion of the planarization layer (PL) in the bending area (BA); and
second and third signal lines (TW, RW) connected to the first and second touch electrodes (Tx, Rx) respectively, the second and third signal lines (TW, RW) extending from the link area (LA) to the bending area (BA) and arranged directly on the second portion of the planarization layer (PL) in parallel with the first signal line link pattern (DLP) in the bending area (BA),
wherein the first organic insulation layer (INS1) covers the first touch electrode (Tx) in the active area (AA), the first signal line (DL) extended from the active area (AA) in the link area (LA), the second signal line (TW), and the third signal line (RW), and wherein the first organic insulation layer (INS1) is disposed directly on the first signal line link pattern (DLP), the second signal line (TW) and the third signal line (RW) in the bending area (BA).

2. The electroluminescent display device (10) of claim 1, wherein the first signal line (DL) comprises a first portion of a first metal layer (M1), the second signal line (TW) and the third signal line (RW) comprise a first portion and a second portion of a second metal layer (M2), respectively, and the pad area (PA) includes:
a first signal pad (DP) comprising a second portion of the first metal layer (M1) and a third portion of the second metal layer (M2) disposed on the second portion of the first metal layer (M1) and connected to the first signal line (DL) in the link area (LA);
a second signal pad (TP) comprising a third portion of the first metal layer (M1) and a fourth portion of the second metal layer (M2) disposed on the third portion of the first metal layer (M1) and extended from the second signal line (TW) in the link area (LA); and
a third signal pad (RP) comprising a fourth portion of the first metal layer (M1) and a fifth portion of the second metal layer (M2) disposed on the fourth portion of the first metal layer (M1) and extended from the third signal line (RW) in the link area (LA).

3. An electroluminescent display device (10) comprising:
a substrate (SUB) having an active area (AA), and a bezel area (ZA) disposed outside the active area (AA), wherein the bezel area (ZA) includes a bending area (BA), a link area (LA) between the active area (AA) and the bending area (BA), and a pad area (PA) adjacent to the bending area (BA);
a gate insulation layer (GI) disposed on the substrate (SUB) in the active area (AA), the link area (LA) and the pad area (PA), but not in the bending area (BA);
a first portion of a planarization layer (PL) disposed in the active area (AA), and at least partially covering a first signal line (DL) extended from the active area (AA) to the link area (LA);
a second portion of the planarization layer (PL) disposed in the bending area (BA) and formed at a time of forming the first portion of the planarization layer (PL);
wherein the planarization layer (PL) is made of organic insulation material,
first and second touch electrodes (Tx, Rx) disposed to cross over each other on an encapsulation layer (ENC) above the first portion of the planarization layer (PL) with a first organic insulation layer (INS1) disposed between the first and second touch electrodes (Tx, Rx), wherein the first organic insulation layer (INS1) covers the first touch electrode (Tx) in the active area (AA) and the first signal line (DL) extended from the active area (AA) in the link area (LA) and is disposed directly on the second portion of the planarization layer (PL) in the bending area (BA);
a first signal line link pattern (DLP) connected to the first signal line (DL) in the link area (LA) through a contact hole passing through the first organic insulation layer (INS1), wherein the first signal line link pattern (DLP) is disposed directly on the first organic insulation layer (INS1) in the bending area (BA) covering the second portion of the planarization layer (PL) in the bending area (BA); and
second and third signal lines (TW, RW) connected to the first and second touch electrodes (Tx, Rx) respectively, and arranged directly on the first organic insulation layer (INS1) in the bending area (BA) and in parallel with the first signal line link pattern (DLP) in the bending area (BA),
further comprising a second organic insulation layer (INS2) covering the second touch electrode (Rx) in the active area (AA), the first signal line link pattern (DLP), the second signal line (TW), and the third signal line (RW), wherein the second organic insulation layer (INS2) is disposed directly on the first signal line link pattern (DLP), the second signal line (TW) and the third signal line (RW) in the bending area (BA).

4. The electroluminescent display device of claim 3, wherein the first signal line (DL) comprises a first portion of a first metal layer (M1), the second signal line (TW) and the third signal line (RW) comprise a first portion and a second portion of a second metal layer (M2), respectively, and the pad area (PA) includes:
a first signal pad (DP) comprising a second portion of the first metal layer (M1), and a a third portion of the second metal layer (M2) disposed on the second portion of the first metal layer (M1) and connected to the first signal line (DL) in the link area (LA);
a second signal pad (TP) comprising a third portion of the first metal layer (M1), and a fourth portion of the second metal layer (M2) disposed on the third portion of the first metal layer (M1) and extended from the second signal line (TW) in the link area (LA); and
a third signal pad (RP) comprising a fourth portion of the first metal layer (M1), and a fifth portion of the second metal layer (M2) disposed on the fourth portion of the first metal layer (M1) and extended from the third signal line (RW) in the link area (LA).

5. The electroluminescent display device (10) of claim 1, further comprising:
a second signal line link pattern (DLP2) disposed on the first organic insulation layer (INS1) covering the first signal line link pattern (DLP1) and the second and third signal lines (TW, RW), and connected to the first signal line link pattern (DLP1);
a wire layer connected to the second signal line (TW);
a wire layer (RW2) connected to the third signal line (RW); and
a second organic insulation layer (INS2) covering the second signal line link pattern (DLP2), and the wire layers (RW2) connected to the second and third signal lines (TW, RW).

6. The electroluminescent display device of claim 5, wherein
the second signal line link pattern (DLP2) is connected to the first signal line link pattern (DLP1) through a contact hole passing through the first organic insulation layer (INS1) in the link area (LA).

7. The electroluminescent display device of claim 6, wherein the first signal line (DL) comprises a first portion of a first metal layer (M1), the second signal line (TW) and the third signal line (RW) comprise a first portion and a second portion of a second metal layer (M2), respectively, and the pad area (PA) includes:
a first signal pad (DP) comprising a second portion of the first metal layer (M1), a third portion of the second metal layer (M2) disposed on the second portion of the first metal layer (M1) and extended from the first signal line link pattern (DLP1) connected to the first signal line (DL) in the link area (LA), and a first portion of a third metal layer (M3) extended from the second signal line link pattern (DLP2) connected to the first signal line (DL)in the link area (LA);
a second signal pad (TP) comprising a third portion of the first metal layer (M1) a fourth portion of the second metal layer (M2) disposed on the third portion of the first metal layer (M1) and extended from the second signal line (TW), and a second portion of the third metal layer (M3) disposed on the fourth portion of the second metal layer (M2) and extended from the wire layer connected to the second signal line (TW) in the link area (LA); and
a third signal pad (RP) comprising a fourth portion of the first metal layer (M1), a fifth portion of the second metal layer (M2) disposed on the fourth portion of the first metal layer (M1) and extended from the third signal line (RW), and a third portion of the third metal layer (M3) disposed on the fifth portion of the fifth portion of the second metal layer (M2) and extended from the wire layer (RW2) connected to the third signal line (RW) in the link area (LA).

8. The electroluminescent display device of any one of claims 5 to 7, wherein
the second organic insulation layer (INS2) covers the second touch electrode (Rx) in the active area (AA), and the second signal line link pattern (DLP2), and the wire layers connected to the second and third signal lines (TW, RW) extended from the active area (AA) in the bezel area (ZA).

9. The electroluminescent display device of claim 8, wherein the second signal line link pattern (DLP2) is connected to the first signal line link pattern (DLP1) through a plurality of contact holes passing the first organic insulation layer (INS1) in the bending area (BA),
the wire layer connected to the second signal line (TW) is connected to the second signal line (TW) through a plurality of contact holes passing the first organic insulation layer (INS1) in the bending area (BA), and
the wire layer (RW2) connected to the third signal line (RW) is connected to the third signal line (RW) through a plurality of contact holes passing the first organic insulation layer (INS1) in the bending area (BA).

10. The electroluminescent display device of any one of claims 5 to 7, wherein each of the first signal line link pattern (DLP1) and the second signal line link pattern (DLP2) are divided into a plurality in the bending area (BA), the divided first signal line link patterns (DLP1a, DLP1b) are connected to each other by the divided second signal line link patterns (DLP2a, DLP2b, DLP2c), and the divided second signal line link patterns (DLP2a, DLP2b, DLP2c) are connected to each other by the divided first signal line link patterns (DLP1a, DLP1b).

11. The electroluminescent display device of claim 8, wherein each of the second signal line (TW) and the wire layer connected to the second signal line (TW) are divided into a plurality of segments in the bending area (BA), wherein two segments of the divided second signal line (TW) are connected to each other by a segment of the divided wire layer, and two segments of the divided wire layer are connected to each other by a segment of the divided second signal line, and
wherein each of the third signal line (RW) and the wire layer (RW2) connected to the third signal line (RW) are divided into a plurality of segments in the bending area (BA), wherein two segments (RW1a, RW1b) of the divided third signal line (RW1) are connected to each other by a segment (RW2b) of the divided wire layer (RW2), and two segments (RW2a, RW2b) of the divided wire layer (RW2) are connected to each other by a segment (RW1a) of the divided third signal line (RW1).

## Patentansprüche

1. Eine Elektrolumineszenz-Anzeigevorrichtung (10), aufweisend:
ein Substrat (SUB), das einen aktiven Bereich (AA) und einen außerhalb des aktiven Bereichs (AA) angeordneten Einfassungsbereich (ZA) aufweist, wobei der Einfassungsbereich (ZA) einen Biegebereich (BA), einen Verbindungsbereich (LA) zwischen dem aktiven Bereich (AA) und dem Biegebereich (BA) und einen an den Biegebereich (BA) angrenzenden Padbereich (PA) aufweist;
eine Gate-Isolierungsschicht (GI), die auf dem Substrat (SUB) in dem aktiven Bereich (AA), dem Verbindungsbereich (LA) und dem Padbereich (PA), jedoch nicht in dem Biegebereich (BA) angeordnet ist;
einen ersten Abschnitt einer Planarisierungsschicht (PL), der in dem aktiven Bereich (AA) angeordnet ist und zumindest teilweise eine erste Signalleitung (DL) überdeckt, die sich von dem aktiven Bereich (AA) zu dem Verbindungsbereich (LA) erstreckt; und
einen zweiten Abschnitt der Planarisierungsschicht (PL), der in dem Biegebereich (BA) angeordnet ist und zu einem Zeitpunkt des Bildens des ersten Abschnitts der Planarisierungsschicht (PL) gebildet ist;
wobei die Planarisierungsschicht (PL) aus einem organischen isolierenden Material gebildet ist,
wobei eine erste und eine zweite Berührungselektrode (Tx, Rx) derart angeordnet sind, dass sie einander auf einer Verkapselungsschicht (ENC) über dem ersten Abschnitt der Planarisierungsschicht (PL) überkreuzen, wobei eine erste organische isolierende Schicht (INS1) zwischen der ersten und der zweiten Berührungselektrode (Tx, Rx) angeordnet ist;
eine erste Signalleitungs-Verbindungsstruktur (DLP), die mit der ersten Signalleitung (DL) in dem Verbindungsbereich (LA) verbunden ist und sich zu dem Biegebereich (BA) erstreckt und direkt auf dem zweiten Abschnitt der Planarisierungsschicht (PL) in dem Biegebereich (BA) angeordnet ist; und
eine zweite und eine dritte Signalleitung (TW, RW), die in zugeordneter Weise mit der ersten und der zweiten Berührungselektrode (Tx, Rx) verbunden sind, wobei sich die zweite und die dritte Signalleitung (TW, RW) von dem Verbindungsbereich (LA) zu dem Biegebereich (BA) erstrecken und direkt auf dem zweiten Abschnitt der Planarisierungsschicht (PL) parallel zu der ersten Signalleitungs-Verbindungsstruktur (DLP) in dem Biegebereich (BA) angeordnet sind,
wobei die erste organische isolierende Schicht (INS1) die erste Berührungselektrode (Tx) in dem aktiven Bereich (AA), die erste Signalleitung (DL), die sich von dem aktiven Bereich (AA) in dem Verbindungsbereich (LA) erstreckt, die zweite Signalleitung (TW) und die dritte Signalleitung (RW) überdeckt, und wobei die erste organische isolierende Schicht (INS1) direkt auf der ersten Signalleitungs-Verbindungsstruktur (DLP), der zweiten Signalleitung (TW) und der dritten Signalleitung (RW) in dem Biegebereich (BA) angeordnet ist.

2. Die Elektrolumineszenz-Anzeigevorrichtung (10) gemäß Anspruch 1, wobei die erste Signalleitung (DL) einen ersten Abschnitt einer ersten Metallschicht (M1) aufweist, die zweite Signalleitung (TW) und die dritte Signalleitung (RW) in zugeordneter Weise einen ersten Abschnitt und einen zweiten Abschnitt einer zweiten Metallschicht (M2) aufweisen, und der Pad-Bereich (PA) aufweist:
ein erstes Signalpad (DP), das einen zweiten Abschnitt der ersten Metallschicht (M1) und einen dritten Abschnitt der zweiten Metallschicht (M2), der auf dem zweiten Abschnitt der ersten Metallschicht (M1) angeordnet ist und mit der ersten Signalleitung (DL) in dem Verbindungsbereich (LA) verbunden ist, aufweist;
ein zweites Signalpad (TP), das einen dritten Abschnitt der ersten Metallschicht (M1) und einen vierten Abschnitt der zweiten Metallschicht (M2), der auf dem dritten Abschnitt der ersten Metallschicht (M1) angeordnet ist und sich von der zweiten Signalleitung (TW) in dem Verbindungsbereich (LA) erstreckt, aufweist; und
ein drittes Signalpad (RP), das einen vierten Abschnitt der ersten Metallschicht (M1) und einen fünften Abschnitt der zweiten Metallschicht (M2), der auf dem vierten Abschnitt der ersten Metallschicht (M1) angeordnet ist und sich von der dritten Signalleitung (RW) in dem Verbindungsbereich (LA) erstreckt, aufweist.

3. Eine Elektrolumineszenz-Anzeigevorrichtung (10), aufweisend:
ein Substrat (SUB), das einen aktiven Bereich (AA) und einen außerhalb des aktiven Bereichs (AA) angeordneten Einfassungsbereich (ZA) aufweist, wobei der Einfassungsbereich (ZA) einen Biegebereich (BA), einen Verbindungsbereich (LA) zwischen dem aktiven Bereich (AA) und dem Biegebereich (BA) und einen an den Biegebereich (BA) angrenzenden Padbereich (PA) aufweist;
eine Gate-Isolierungsschicht (GI), die auf dem Substrat (SUB) in dem aktiven Bereich (AA), dem Verbindungsbereich (LA) und dem Padbereich (PA), jedoch nicht in dem, Biegebereich (BA) angeordnet ist;
einen ersten Abschnitt einer Planarisierungsschicht (PL), der in dem aktiven Bereich (AA) angeordnet ist und zumindest teilweise eine erste Signalleitung (DL) überdeckt, die sich von dem aktiven Bereich (AA) zu dem Verbindungsbereich (LA) erstreckt;
einen zweiten Abschnitt der Planarisierungsschicht (PL), der in dem Biegebereich (BA) angeordnet ist und zu einem Zeitpunkt des Bildens des ersten Abschnitts der Planarisierungsschicht (PL) gebildet ist;
wobei die Planarisierungsschicht (PL) aus einem organischen isolierenden Material gebildet ist,
wobei eine erste und eine zweite Berührungselektrode (Tx, Rx) derart angeordnet sind, dass sie einander auf einer Verkapselungsschicht (ENC) über dem ersten Abschnitt der Planarisierungsschicht (PL) überkreuzen, wobei eine erste organische isolierende Schicht (INS1) zwischen der ersten und der zweiten Berührungselektrode (Tx, Rx) angeordnet ist, wobei die erste organische isolierende Schicht (INS1) die erste Berührungselektrode (Tx) in dem aktiven Bereich (AA) und die erste Signalleitung (DL), die sich von dem aktiven Bereich (AA) in dem Verbindungsbereich (LA) erstreckt, überdeckt und direkt auf dem zweiten Abschnitt der Planarisierungsschicht (PL) in dem Biegebereich (BA) angeordnet ist;
eine erste Signalleitungs-Verbindungsstruktur (DLP), die durch ein Kontaktloch, das durch die erste organische isolierende Schicht (INS1) hindurchführt, mit der ersten Signalleitung (DL) in dem Verbindungsbereich (LA) verbunden ist, wobei die erste Signalleitungs-Verbindungsstruktur (DLP) direkt auf der ersten organischen isolierenden Schicht (INS1) in dem Biegebereich (BA) angeordnet ist, die den zweiten Abschnitt der Planarisierungsschicht (PL) in dem Biegebereich (BA) überdeckt; und
eine zweite und eine dritte Signalleitung (TW, RW), die in zugeordneter Weise mit der ersten und der zweiten Berührungselektrode (Tx, Rx) verbunden sind und direkt auf der ersten organischen isolierenden Schicht (INS1) in dem Biegebereich (BA) und parallel zu der ersten Signalleitungs-Verbindungsstruktur (DLP) in dem Biegebereich (BA) angeordnet sind,
ferner aufweisend eine zweite organische isolierende Schicht (INS2), die die zweite Berührungselektrode (Rx) in dem aktiven Bereich (AA), die erste Signalleitungs-Verbindungsstruktur (DLP), die zweite Signalleitung (TW) und die dritte Signalleitung (RW) überdeckt, wobei die zweite organische isolierende Schicht (INS2) direkt auf der ersten Signalleitungs-Verbindungsstruktur (DLP), der zweiten Signalleitung (TW) und der dritten Signalleitung (RW) in dem Biegebereich (BA) angeordnet ist.

4. Die Elektrolumineszenz-Anzeigevorrichtung gemäß Anspruch 3, wobei die erste Signalleitung (DL) einen ersten Abschnitt einer ersten Metallschicht (M1) aufweist, die zweite Signalleitung (TW) und die dritte Signalleitung (RW) in zugeordneter Weise einen ersten Abschnitt und einen zweiten Abschnitt einer zweiten Metallschicht (M2) aufweisen, und der Padbereich (PA) aufweist:
ein erstes Signalpad (DP), das einen zweiten Abschnitt der ersten Metallschicht (M1) und einen dritten Abschnitt der zweiten Metallschicht (M2), der auf dem zweiten Abschnitt der ersten Metallschicht (M1) angeordnet ist und mit der ersten Signalleitung (DL) in dem Verbindungsbereich (LA) verbunden ist, aufweist;
ein zweites Signalpad (TP), das einen dritten Abschnitt der ersten Metallschicht (M1) und einen vierten Abschnitt der zweiten Metallschicht (M2), der auf dem dritten Abschnitt der ersten Metallschicht (M1) angeordnet ist und sich von der zweiten Signalleitung (TW) in dem Verbindungsbereich (LA) erstreckt, aufweist; und
ein drittes Signalpad (RP), das einen vierten Abschnitt der ersten Metallschicht (M1) und einen fünften Abschnitt der zweiten Metallschicht (M2), der auf dem vierten Abschnitt der ersten Metallschicht (M1) angeordnet ist und sich von der dritten Signalleitung (RW) in dem Verbindungsbereich (LA) erstreckt, aufweist.

5. Die Elektrolumineszenz-Anzeigevorrichtung (10) gemäß Anspruch 1, ferner aufweisend:
eine zweite Signalleitungs-Verbindungsstruktur (DLP2), die auf der ersten organischen isolierenden Schicht (INS1) angeordnet ist, die die erste Signalleitungs-Verbindungsstruktur (DLP1) und die zweite und die dritte Signalleitung (TW, RW) überdeckt, und mit der ersten Signalleitungs-Verbindungsstruktur (DLP1) verbunden ist;
eine Drahtschicht, die mit der zweiten Signalleitung (TW) verbunden ist;
eine Drahtschicht (RW2), die mit der dritten Signalleitung (RW) verbunden ist; und
eine zweite organische isolierende Schicht (INS2), die die zweite Signalleitungs-Verbindungsstruktur (DLP2) und die Drahtschichten (RW2), die mit der zweiten und der dritten Signalleitung (TW, RW) verbunden sind, überdeckt.

6. Die Elektrolumineszenz-Anzeigevorrichtung gemäß Anspruch 5, wobei
die zweite Signalleitungs-Verbindungsstruktur (DLP2) durch ein Kontaktloch, das durch die erste organische isolierende Schicht (INS1) in dem Verbindungsbereich (LA) hindurchführt, mit der ersten Signalleitungs-Verbindungsstruktur (DLP1) verbunden ist.

7. Die Elektrolumineszenz-Anzeigevorrichtung gemäß Anspruch 6, wobei die erste Signalleitung (DL) einen ersten Abschnitt einer ersten Metallschicht (M1) aufweist, die zweite Signalleitung (TW) und die dritte Signalleitung (RW) in zugeordneter Weise einen ersten Abschnitt und einen zweiten Abschnitt einer zweiten Metallschicht (M2) aufweisen, und der Padbereich (PA) aufweist:
ein erstes Signal-Pad (DP), das einen zweiten Abschnitt der ersten Metallschicht (M1), einen dritten Abschnitt der zweiten Metallschicht (M2), der auf dem zweiten Abschnitt der ersten Metallschicht (M1) angeordnet ist und sich von der ersten Signalleitungs-Verbindungsstruktur (DLP1) erstreckt, die mit der ersten Signalleitung (DL) in dem Verbindungsbereich (LA) verbunden ist, und einem ersten Abschnitt einer dritten Metallschicht (M3), der sich von der zweiten Signalleitungs-Verbindungsstruktur (DLP2) erstreckt, die mit der ersten Signalleitung (DL) in dem Verbindungsbereich (LA) verbunden ist, aufweist;
ein zweites Signal-Pad (TP), das einen dritten Abschnitt der ersten Metallschicht (M1), einen vierten Abschnitt der zweiten Metallschicht (M2), der auf dem dritten Abschnitt der ersten Metallschicht (M1) angeordnet ist und sich von der zweiten Signalleitung (TW) erstreckt, und einen zweiten Abschnitt der dritten Metallschicht (M3), der auf dem vierten Abschnitt der zweiten Metallschicht (M2) angeordnet ist und sich von der mit der zweiten Signalleitung (TW) verbundenen Drahtschicht in dem Verbindungsbereich (LA) erstreckt, aufweist; und
ein drittes Signal-Pad (RP), das einen vierten Abschnitt der ersten Metallschicht (M1), einen fünften Abschnitt der zweiten Metallschicht (M2), der auf dem vierten Abschnitt der ersten Metallschicht (M1) angeordnet ist und sich von der dritten Signalleitung (RW) erstreckt, und einen dritten Abschnitt der dritten Metallschicht (M3), der auf dem fünften Abschnitt des fünften Abschnitts der zweiten Metallschicht (M2) angeordnet ist und sich von der Drahtschicht (RW2), die mit der dritten Signalleitung (RW) in dem Verbindungsbereich (LA) verbunden ist, erstreckt, aufweist.

8. Die Elektrolumineszenz-Anzeigevorrichtung gemäß einem der Ansprüche 5 bis 7, wobei
die zweite organische isolierende Schicht (INS2) die zweite Berührungselektrode (Rx) in dem aktiven Bereich (AA) und die zweite Signalleitungs-Verbindungsstruktur (DLP2) und die Drahtschichten, die mit der zweiten und der dritten Signalleitung (TW, RW), die sich von dem aktiven Bereich (AA) in den Einfassungsbereich (ZA) erstrecken, verbunden sind, überdeckt.

9. Die Elektrolumineszenz-Anzeigevorrichtung gemäß Anspruch 8, wobei die zweite Signalleitungs-Verbindungsstruktur (DLP2) durch eine Mehrzahl von Kontaktlöchern, die durch die erste organische isolierende Schicht (INS1) in dem Biegebereich (BA) hindurchführen, mit der ersten Signalleitungs-Verbindungsstruktur (DLP1) verbunden ist,
die mit der zweiten Signalleitung (TW) verbundene Drahtschicht durch eine Mehrzahl von Kontaktlöchern, die durch die erste organische isolierende Schicht (INS1) in dem Biegebereich (BA) hindurchführen, mit der zweiten Signalleitung (TW) verbunden ist, und
die mit der dritten Signalleitung (RW) verbundene Drahtschicht (RW2) durch eine Mehrzahl von Kontaktlöchern, die durch die erste organische isolierende Schicht (INS1) in dem Biegebereich (BA) hindurchführen, mit der dritten Signalleitung (RW) verbunden ist.

10. Die Elektrolumineszenz-Anzeigevorrichtung gemäß einem der Ansprüche 5 bis 7, wobei jede von der ersten Signalleitungs-Verbindungsstruktur (DLP1) und der zweiten Signalleitungs-Verbindungsstruktur (DLP2) in dem Biegebereich (BA) in eine Mehrzahl unterteilt sind, die unterteilten ersten Signalleitungs-Verbindungsstrukturen (DLP1a, DLP1b) mittels der unterteilten zweiten Signalleitungs-Verbindungsstrukturen (DLP2a, DLP2b, DLP2c) miteinander verbunden sind, und die unterteilten zweiten Signalleitungs-Verbindungsstrukturen (DLP2a, DLP2b, DLP2c) mittels der unterteilten ersten Signalleitungs-Verbindungsstrukturen (DLP1a, DLP1b) miteinander verbunden sind.

11. Die Elektrolumineszenz-Anzeigevorrichtung gemäß Anspruch 8, wobei sowohl die zweite Signalleitung (TW) als auch die mit der zweiten Signalleitung (TW) verbundene Drahtschicht in dem Biegebereich (BA) in eine Mehrzahl von Segmenten unterteilt sind, wobei zwei Segmente der unterteilten zweiten Signalleitung (TW) mittels eines Segments der unterteilten Drahtschicht miteinander verbunden sind, und zwei Segmente der unterteilten Drahtschicht mittels eines Segments der unterteilten zweiten Signalleitung miteinander verbunden sind, und
wobei sowohl die dritte Signalleitung (RW) als auch die mit der dritten Signalleitung (RW) verbundene Drahtschicht (RW2) in dem Biegebereich (BA) in eine Mehrzahl von Segmenten unterteilt sind, wobei zwei Segmente (RW1a, RW1b) der unterteilten dritten Signalleitung (RW1) mittels eines Segments (RW2b) der unterteilten Drahtschicht (RW2) miteinander verbunden sind, und zwei Segmente (RW2a, RW2b) der unterteilten Drahtschicht (RW2) mittels eines Segments ( RW1a) der unterteilten dritten Signalleitung (RW1) miteinander verbunden sind.

## Revendications

1. Dispositif d'affichage électroluminescent (10) comprenant :
un substrat (SUB) qui présente une zone active (AA), et une zone d'encadrement (ZA) disposée en dehors de la zone active (AA), dans lequel la zone d'encadrement (ZA) comprend une zone de pliage (BA), une zone de liaison (LA) entre la zone active (AA) et la zone de pliage (BA), et une zone de plage de connexion (PA) adjacente à la zone de pliage (BA) ;
une couche d'isolation de grille (GI) disposée sur le substrat (SUB) dans la zone active (AA), la zone de liaison (LA) et la zone de plage de connexion (PA), mais pas dans la zone de pliage (BA) ;
une première partie d'une couche de planarisation (PL) disposée dans la zone active (AA), et qui couvre en partie au moins une première ligne de signal (DL) s'étendant à partir de la zone active (AA) vers la zone de liaison (LA) ;
une deuxième partie de la couche de planarisation (PL) disposée dans la zone de pliage (BA), et formée au moment de la formation de la première partie de la couche de planarisation (PL) ;
dans lequel la couche de planarisation (PL) est réalisée dans un matériau d'isolation organique,
des premières et deuxièmes électrodes de contact (Tx, Rx) disposées de façon à se croiser les unes les autres sur une couche d'encapsulation (ENC) au-dessus de la première partie de la couche de planarisation (PL), une première couche d'isolation organique (INS1) étant disposée entre les premières et deuxièmes électrodes de contact (Tx, Rx) ;
un premier motif de liaison de ligne de signal (DLP) connecté à la première ligne de signal (DL) dans la zone de liaison (LA), et s'étendant vers la zone de pliage (BA), et qui est disposé directement sur la deuxième partie de la couche de planarisation (PL) dans la zone de pliage (BA) ; et
des deuxième et troisième lignes de signal (TW, RW) connectées aux premières et deuxièmes électrodes de contact (Tx, Rx) respectivement, les deuxième et troisième lignes de signal (TW, RW) s'étendant à partir de la zone de liaison (LA) vers la zone de pliage (BA), et étant disposées directement sur la deuxième partie de la couche de planarisation (PL) parallèlement au premier motif de liaison de ligne de signal (DLP) dans la zone de pliage (BA),
dans lequel la première couche d'isolation organique (INS1) couvre la première électrode de contact (Tx) dans la zone active (AA), la première ligne de signal (DL) s'étendant à partir de la zone active (AA) dans la zone de liaison (LA), la deuxième ligne de signal (TW), et la troisième ligne de signal (RW), et dans lequel la première couche d'isolation organique (INS1) est disposée directement sur le premier motif de liaison de ligne de signal (DLP), la deuxième ligne de signal (TW) et la troisième ligne de signal (RW) dans la zone de pliage (BA).

2. Dispositif d'affichage électroluminescent (10) selon la revendication 1, dans lequel la première ligne de signal (DL) comprend une première partie d'une première couche métallique (M1), la deuxième ligne de signal (TW) et la troisième ligne de signal (RW) comprennent une première partie et une deuxième partie d'une deuxième couche métallique (M2), respectivement, et la zone de plage de connexion (PA) comprend :
une première plage de connexion de signal (DP) comprenant une deuxième partie de la première couche métallique (M1) et une troisième partie de la deuxième couche métallique (M2) disposée sur la deuxième partie de la première couche métallique (M1) et connectée à la première ligne de signal (DL) dans la zone de liaison (LA) ;
une deuxième plage de connexion de signal (TP) comprenant une troisième partie de la première couche métallique (M1) et une quatrième partie de la deuxième couche métallique (M2) disposée sur la troisième partie de la première couche métallique (M1) et s'étendant à partir de la deuxième ligne de signal (TW) dans la zone de liaison (LA) ; et
une troisième plage de connexion de signal (RP) comprenant une quatrième partie de la première couche métallique (M1) et une cinquième partie de la deuxième couche métallique (M2) disposée sur la quatrième partie de la première couche métallique (M1) et s'étendant à partir de la troisième ligne de signal (RW) dans la zone de liaison (LA).

3. Dispositif d'affichage électroluminescent (10) comprenant :
un substrat (SUB) qui présente une zone active (AA), et une zone d'encadrement (ZA) disposée en dehors de la zone active (AA), dans lequel la zone d'encadrement (ZA) comprend une zone de pliage (BA), une zone de liaison (LA) entre la zone active (AA) et la zone de pliage (BA), et une zone de plage de connexion (PA) adjacente à la zone de pliage (BA) ;
une couche d'isolation de grille (GI) disposée sur le substrat (SUB) dans la zone active (AA), la zone de liaison (LA) et la zone de plage de connexion (PA), mais pas dans la zone de pliage (BA) ;
une première partie d'une couche de planarisation (PL) disposée dans la zone active (AA), et qui couvre en partie au moins une première ligne de signal (DL) s'étendant à partir de la zone active (AA) vers la zone de liaison (LA) ;
une deuxième partie de la couche de planarisation (PL) disposée dans la zone de pliage (BA), et formée au moment de la formation de la première partie de la couche de planarisation (PL) ;dans lequel la couche de planarisation (PL) est réalisée dans un matériau d'isolation
organique, des première et deuxième électrodes de contact (Tx, Rx) disposées de façon à se croiser les unes les autres sur une couche d'encapsulation (ENC) au-dessus de la première partie de la couche de planarisation (PL), une première couche d'isolation organique (INS1) étant disposée entre les premières et deuxièmes électrodes de contact (Tx, Rx), dans lequel la première couche d'isolation organique (INS1) couvre la première électrode de contact (Tx) dans la zone active (AA) et la première ligne de signal (DL) s'étendant à partir de la zone active (AA) dans la zone de liaison (LA), et disposée directement sur la deuxième partie de la couche de planarisation (PL) dans la zone de pliage (BA) ;
un premier motif de liaison de ligne de signal (DLP) connecté à la première ligne de signal (DL) dans la zone de liaison (LA) par l'intermédiaire d'un trou de contact qui passe à travers la première couche d'isolation organique (INS1), dans lequel le premier motif de liaison de ligne de signal (DLP) est disposé directement sur la première couche d'isolation organique (INS1) dans la zone de pliage (BA) en couvrant la deuxième partie de la couche de planarisation (PL) dans la zone de pliage (BA) ; et
des deuxième et troisièmes lignes de signal (TW, RW) connectées aux première et deuxième électrodes de contact (Tx, Rx) respectivement, et agencées directement sur la première couche d'isolation organique (INS1) dans la zone de pliage (BA), et parallèles au premier motif de liaison de ligne de signal (DLP) dans la zone de pliage (BA),
comprenant en outre une deuxième couche d'isolation organique (INS2) qui couvre la deuxième électrode de contact (Rx) dans la zone active (AA), le premier motif de liaison de ligne de signal (DLP), la deuxième ligne de signal (TW), et la troisième ligne de signal (RW), dans lequel la deuxième couche d'isolation organique (INS2) est disposée directement sur le premier motif de liaison de ligne de signal (DLP), la deuxième ligne de signal (TW) et la troisième ligne de signal (RW) dans la zone de pliage (BA).

4. Dispositif d'affichage électroluminescent selon la revendication 3, dans lequel la première ligne de signal (DL) comprend une première partie d'une première couche métallique (M1), la deuxième ligne de signal (TW) et la troisième ligne de signal (RW) comprennent une première partie et une deuxième partie d'une deuxième couche métallique (M2), respectivement, et la zone de plage de connexion (PA) comprend :
une première plage de connexion de signal (DP) comprenant une deuxième partie de la première couche métallique (M1) et une troisième partie de la deuxième couche métallique (M2) disposée sur la deuxième partie de la première couche métallique (M1) et connectée à la première ligne de signal (DL) dans la zone de liaison (LA) ;
une deuxième plage de connexion de signal (TP) comprenant une troisième partie de la première couche métallique (M1), et une quatrième partie de la deuxième couche métallique (M2) disposée sur la troisième partie de la première couche métallique (M1) et s'étendant à partir de la deuxième ligne de signal (TW) dans la zone de liaison (LA) ; et
une troisième plage de connexion de signal (RP) comprenant une quatrième partie de la première couche métallique (M1), et une cinquième partie de la deuxième couche métallique (M2) disposée sur la quatrième partie de la première couche métallique (M1) et s'étendant à partir de la troisième ligne de signal (RW) dans la zone de liaison (LA).

5. Dispositif d'affichage électroluminescent (10) selon la revendication 1, comprenant en outre :
un deuxième motif de liaison de ligne de signal (DLP2) disposé sur la première couche d'isolation organique (INS1) qui couvre le premier motif de liaison de ligne de signal (DLP1) et les deuxième et troisième lignes de signal (TW, RW), et qui est connecté au premier motif de liaison de ligne de signal (DLP1) ;
une couche filaire connectée à la deuxième ligne de signal (TW) ;
une couche filaire (RW2) connectée à la troisième ligne de signal (RW) ; et
une deuxième couche d'isolation organique (INS2) qui couvre le deuxième motif de liaison de ligne de signal (DLP2), et les couches filaires (RW2) connectées aux deuxième et troisième lignes de signal (TW, RW).

6. Dispositif d'affichage électroluminescent selon la revendication 5, dans lequel
le deuxième motif de liaison de ligne de signal (DLP2) est connecté au premier motif de liaison de ligne de signal (DLP1) par l'intermédiaire d'un trou de contact qui passe à travers la première couche d'isolation organique (INS1) dans la zone de liaison (LA).

7. Dispositif d'affichage électroluminescent selon la revendication 6, dans lequel la première ligne de signal (DL) comprend une première partie d'une première couche métallique (M1), la deuxième ligne de signal (TW) et la troisième ligne de signal (RW) comprennent une première partie et une deuxième partie d'une deuxième couche métallique (M2), respectivement, et la zone de plage de connexion (PA) comprend :
une première plage de connexion de signal (DP) comprenant une deuxième partie de la première couche métallique (M1), une troisième partie de la deuxième couche métallique (M2) disposée sur la deuxième partie de la première couche métallique (M1), et s'étendant à partir à partir du premier motif de liaison de ligne de signal (DLP1) connectée à la première ligne de signal (DL) dans la zone de liaison (LA), et une première partie d'une troisième couche métallique (M3) s'étendant à partir du deuxième motif de liaison de ligne de signal (DLP2) connectée à la première ligne de signal (DL) dans la zone de liaison (LA) ;
une deuxième plage de connexion de signal (TP) comprenant une troisième partie de la première couche métallique (M1), une quatrième partie de la deuxième couche métallique (M2) disposée sur la troisième partie de la première couche métallique (M1) et s'étendant à partir de la deuxième ligne de signal (TW), et une deuxième partie de la troisième couche métallique (M3) disposée sur la quatrième partie de la deuxième couche métallique (M2) et s'étendant à partir de la couche filaire connectée à la deuxième ligne de signal (TW) dans la zone de liaison (LA) ; et
une troisième plage de connexion de signal (RP) comprenant une quatrième partie de la première couche métallique (M1), une cinquième partie de la deuxième couche métallique (M2) disposée sur la quatrième partie de la première couche métallique (M1), et s'étendant à partir de la troisième ligne de signal (RW), et une troisième partie de la troisième couche métallique (M3) disposée sur la cinquième partie de la cinquième partie de la deuxième couche métallique (M2), et s'étendant à partir de la couche filaire (RW2) connectée à la troisième ligne de signal (RW) dans la zone de liaison (LA).

8. Dispositif d'affichage électroluminescent selon l'une quelconque des revendications 5 à 7, dans lequel
la deuxième couche d'isolation organique (INS2) couvre la deuxième électrode de contact (Rx) dans la zone active (AA), et le deuxième motif de liaison de ligne de signal (DLP2), et les couches filaires connectées aux deuxième et troisième lignes signal (TW, RW) s'étendant à partir de la zone active (AA) dans la zone d'encadrement (ZA).

9. Dispositif d'affichage électroluminescent selon la revendication 8, dans lequel le deuxième motif de liaison de ligne de signal (DLP2) est connecté au premier motif de liaison de ligne de signal (DLP1) par l'intermédiaire d'une pluralité de trous de contact qui passent à travers la première couche d'isolation organique (INS1) dans la zone de pliage (BA),
la couche filaire connectée à la deuxième ligne de signal (TW) est connectée à la deuxième ligne de signal (TW) par l'intermédiaire d'une pluralité de trous de contact qui passent à travers la première couche d'isolation organique (INS1) dans la zone de pliage (BA), et
la couche filaire (RW2) connectée à la troisième ligne de signal (RW) est connectée à la troisième ligne de signal (RW) par l'intermédiaire d'une pluralité de trous de contact qui passent à travers la première couche d'isolation organique (INS1) dans la zone de pliage (BA).

10. Dispositif d'affichage électroluminescent selon l'une quelconque des revendications 5 à 7, dans lequel chacun du premier motif de liaison de ligne de signal (DLP1) et du deuxième motif de liaison de ligne de signal (DLP2), est divisé en une pluralité de motifs dans la zone de pliage (BA), les premiers motifs de liaison de ligne de signal divisés (DLP1a, DLP1b) sont connectés les uns aux autres par les deuxièmes motifs de liaison de ligne de signal divisés (DLP2a, DLP2b, DLP2c), et les deuxièmes motifs de liaison de ligne de signal divisés (DLP2a, DLP2b, DLP2c) sont connectés les uns aux autres par les premiers motifs de liaison de ligne de signal divisés (DLP1a, DLP1b).

11. Dispositif d'affichage électroluminescent selon la revendication 8, dans lequel chacune de la deuxième ligne de signal (TW) et de la couche filaire connectée à la deuxième ligne de signal (TW), est divisée en une pluralité de segments dans la zone de pliage (BA), dans lequel deux segments de la deuxième ligne de signal divisée (TW), sont connectés l'un à l'autre par un segment de la couche filaire divisée, et deux segments de la couche filaire divisée, sont connectés l'un à l'autre par un segment de la deuxième ligne divisée, et
dans lequel chacune de la troisième ligne de signal (RW) et de la couche filaire (RW2) connectée à la troisième ligne de signal (RW), est divisée en une pluralité de segments dans la zone de pliage (BA), dans lequel deux segments (RW1a, RW1b) de la troisième ligne de signal divisée (RW1), sont connectés l'un à l'autre par un segment (RW2b) de la couche filaire divisée (RW2), et deux segments (RW2a, RW2b) de la couche filaire divisée (RW2), sont connectés l'un à l'autre par un segment (RW1a) de la troisième ligne divisée (RW1).
